(19) Europäisches Patentamt
European Patent Office
Office européen des brevets

(11) EP 4 502 056 A1

(12) **EUROPEAN PATENT APPLICATION**
published in accordance with Art. 153(4) EPC

(43) Date of publication:
**05.02.2025 Bulletin 2025/06**

(21) Application number: **23775063.3**

(22) Date of filing: **24.03.2023**

(51) International Patent Classification (IPC):
***C08L 63/00*** (2006.01) ***B32B 27/38*** (2006.01)
***C08K 3/013*** (2018.01) ***C08K 3/38*** (2006.01)
***C08K 5/3415*** (2006.01) ***C08L 61/34*** (2006.01)
***C08L 101/02*** (2006.01) ***H05K 1/03*** (2006.01)

(52) Cooperative Patent Classification (CPC):
**B32B 27/38; C08K 3/013; C08K 3/38; C08K 5/3415; C08L 61/34; C08L 63/00; C08L 101/02; H05K 1/03**

(86) International application number:
**PCT/JP2023/011692**

(87) International publication number:
**WO 2023/182470 (28.09.2023 Gazette 2023/39)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **24.03.2022 JP 2022047899**
**24.03.2022 JP 2022047900**

(71) Applicant: **Mitsubishi Chemical Corporation**
**Tokyo 100-8251 (JP)**

(72) Inventors:
- **TANAKA, Toshiyuki**
  **Tokyo 100-8251 (JP)**
- **TANIGUCHI, Sae**
  **Tokyo 100-8251 (JP)**
- **SAWAMURA, Toshiyuki**
  **Tokyo 100-8251 (JP)**
- **YAMAMOTO, Yumiko**
  **Tokyo 100-8251 (JP)**
- **HIDAKA, Katsuhiko**
  **Tokyo 100-8251 (JP)**

(74) Representative: **Hoffmann Eitle**
**Patent- und Rechtsanwälte PartmbB**
**Arabellastraße 30**
**81925 München (DE)**

(54) **THERMOSETTING RESIN COMPOSITION, THERMALLY CONDUCTIVE RESIN SHEET, HEAT-DISSIPATING LAYERED PRODUCT, HEAT-DISSIPATING CIRCUIT BOARD, SEMICONDUCTOR DEVICE AND POWER MODULE**

(57) By using a thermosetting resin composition containing a thermosetting resin, an inorganic filler, and a polymer having a mass average molecular weight of 10,000 or more, wherein the thermosetting resin composition includes boron nitride agglomerated particles as the inorganic filler, and includes an epoxy compound and a benzoxazine compound as the thermosetting resin, and a ratio of a mass content of the boron nitride agglomerated particles to a mass content of the benzoxazine compound (boron nitride agglomerated particles/benzoxazine) is 5 or more and 50 or less, a thermally conductive sheet having thermal conductivity and heat resistance can be formed. In addition, the thermosetting resin composition can be formed into a film without any problem when forming a sheet, and sufficient adhesive strength can be obtained when cured.

Fig. 1

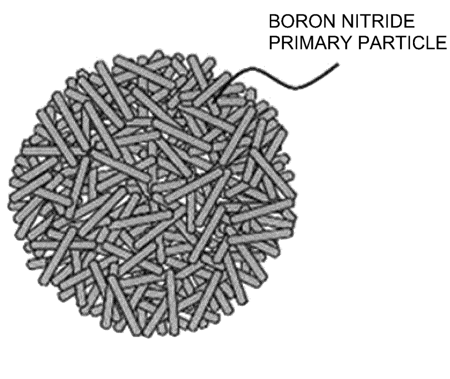


EP 4 502 056 A1

## Description

### Technical Field

The present invention relates to a thermosetting resin composition having a thermosetting property, a thermally conductive resin sheet formed from a cured product of such resin composition, a heat-dissipating laminated body, and a heat-dissipating circuit board, semiconductor device, and power module including such thermally conductive resin sheet.

### Background Art

In recent years, power semiconductor devices used in various fields such as railroads, automobiles, industrial applications, and general home appliances have been evolving from conventional Si power semiconductors into power semiconductors that use SiC, AlN, GaN, and the like in order to reduce size, reduce costs, and improve efficiency.

A power semiconductor device is generally used as a power semiconductor module that packages a plurality of semiconductor devices arranged on a common heat sink.

In order to achieve practical implementation of such power semiconductor devices, various issues have been pointed out. One of those issues is heat generation from the device. Power semiconductor devices can achieve high output and high density by operating at high temperatures, but the heat generated during device switching and the like may reduce the reliability of the power semiconductor device.

Further, in recent years, heat generation due to the increased density of integrated circuits has become a major issue in the electrical and electronic fields, and how to dissipate heat has become an urgent issue in these fields as well. For example, to ensure stable operation of the semiconductor device used to control the central processing unit in a personal computer, the motor in an electric vehicle, and the like, a heat sink, heat dissipation fins, or the like is essential for heat dissipation, and the member that joins the semiconductor device with the heat sink or the like needs to have both thermal conductivity and insulation properties.

Ceramic substrates with high thermal conductivity, such as alumina substrates and aluminum nitride substrates, have conventionally been used as a member that can achieve both thermal conductivity and insulation properties. However, ceramic substrates have suffered from issues such as being easily broken when subjected to a shock, difficult to form into a thin film, and difficult to miniaturize.

Therefore, heat-dissipating sheets that use a thermosetting resin such as an epoxy resin and an inorganic filler have been proposed.

Regarding heat-dissipating sheets that use a thermosetting resin and an inorganic filler, for example, Patent Literature 1 proposes a heat-dissipating resin sheet containing an epoxy resin having a Tg of 60°C or lower and boron nitride, wherein the boron nitride has a content of 30% by volume or more and 60% by volume or less.

Boron nitride (hereinafter also referred to as "BN") is a ceramic having insulation properties, and is a material that in recent years has been drawing particular focus in the electrical and electronic material fields because it has excellent thermal conductivity, solid lubricity, chemical stability, and heat resistance.

Further, the following proposals have been made regarding compositions or sheets containing benzoxazine.

Patent Literature 2 proposes an epoxy resin composition including a benzoxazine derivative, an epoxy resin, and a curing accelerator.

Patent Literature 3 proposes a resin film with a base material, which includes a base material and a resin film provided in contact with the base material, wherein the resin film includes an epoxy resin and a benzoxazine compound.

### Citation List

#### Patent Literature

Patent Literature 1
Japanese Patent Laid-Open No. 2017-036415
Patent Literature 2
Japanese Patent No. 5627196
Patent Literature 3
Japanese Patent Laid-Open No. 2021-084968

Summary of Invention

Technical Problem

When a thermally conductive resin sheet formed from a thermosetting resin composition is used in a power semiconductor device or the like, heat resistance is required because electronic components and the like are mounted on the thermally conductive resin sheet by reflow.

The use of a combination of an epoxy compound and a benzoxazine compound is considered to be one effective means for increasing the heat resistance of a thermally conductive resin sheet.

However, in a case where a resin composition including an epoxy compound and a benzoxazine compound contains agglomerated particles composed of boron nitride as an inorganic filler, when the composition is formed into a sheet, it has become clear that there may be problems with film formation, such as the thickness becoming uneven during winding, and the sheet may crack or tear. In addition, it has been found that sufficient adhesive strength may not be obtained when laminated with a base material such as a metal plate and cured because the film properties deteriorate and the adhesion with the base material is reduced.

Accordingly, it is an object of the present invention to provide a thermosetting resin composition that can form a thermally conductive sheet having thermal conductivity and heat resistance, that can be further formed into a film without any problem when forming a sheet, and that has sufficient adhesive strength when cured.

Solution to Problem

To solve this problem, the present invention proposes the following modes of a thermosetting resin composition, a thermally conductive resin sheet, a heat-dissipating laminated body, a heat-dissipating circuit board, a semiconductor device, and a power module.

[1] A first mode of the present invention is a thermosetting resin composition including a thermosetting resin, an inorganic filler, and a polymer having a mass average molecular weight of 10,000 or more, wherein the thermosetting resin composition.

includes boron nitride agglomerated particles as the inorganic filler, and
includes an epoxy compound and a benzoxazine compound as the thermosetting resin, and
a ratio of a mass content of the boron nitride agglomerated particles to a mass content of the benzoxazine compound (boron nitride agglomerated particles/benzoxazine) is 5 or more and 50 or less.

[2] A second mode of the present invention is the thermosetting resin composition of the first mode, wherein the benzoxazine compound is solid at 25°C.

[3] A third mode of the present invention is a thermosetting resin composition including a thermosetting resin and an inorganic filler, wherein the thermosetting resin composition.

includes boron nitride agglomerated particles as the inorganic filler, and
includes an epoxy compound and a benzoxazine compound that is liquid at 25°C as the thermosetting resin.

[4] A fourth mode of the present invention is the thermosetting resin composition of the third mode, including a polymer having a mass average molecular weight of 10,000 or more.

[5] A fifth mode of the present invention is the thermosetting resin composition of the third or fourth mode, wherein a ratio of a mass content of the boron nitride agglomerated particles to a mass content of the benzoxazine compound (boron nitride agglomerated particles/benzoxazine) is 50 or less.

[6] A sixth mode of the present invention is the thermosetting resin composition of any one of the first to fifth modes, wherein a proportion of the boron nitride agglomerated particles is 50% by mass or more and 85% by mass or less with respect to 100% by mass of a total solid content of the thermosetting resin composition.

[7] A seventh mode of the present invention is the thermosetting resin composition of any one of the first, second and fourth to sixth modes, wherein the polymer having a mass average molecular weight of 10,000 or more has a functional group that reacts with the epoxy compound.

[8] An eighth mode of the present invention is the thermosetting resin composition of any one of the first, second and fourth to seventh modes, comprising the polymer having a mass average molecular weight of 10,000 or more in a proportion of 10% by mass or more and less than 30% by mass with respect to 100% by mass of a solid content excluding the inorganic filler from the thermosetting resin composition.

[9] A ninth mode of the present invention is the thermosetting resin composition of any one of the first to eighth modes,

wherein a mass ratio of a content of the benzoxazine compound to a content of the epoxy compound in a solid content of the thermosetting resin excluding the inorganic filler (benzoxazine compound/epoxy compound) is less than 0.8.
[10] A tenth mode of the present invention is the thermosetting resin composition of any one of the first to ninth modes, including at least one compound having imidazole as a curing catalyst.
[11] An eleventh mode of the present invention is the thermosetting resin composition of any one of the first to tenth modes, wherein the thermosetting resin includes a polyfunctional epoxy compound having three or more epoxy groups per molecule and having a molecular weight of 650 or less.
[12] A twelfth mode of the present invention is the thermosetting resin composition of the eleventh mode, wherein the polyfunctional epoxy compound is an epoxy compound having four or more glycidyl groups in one molecule.
[13] A thirteenth mode of the present invention is a thermosetting resin sheet formed from the thermosetting resin composition of any one of the first to twelfth modes.
[14] A fourteenth mode of the present invention is a cured product of the thermosetting resin sheet of the thirteenth mode.
[15] A fifteenth mode of the present invention is a thermally conductive resin sheet composed of a cured product of a thermosetting resin composition containing a thermosetting resin and an inorganic filler, wherein

the thermally conductive resin sheet includes boron nitride agglomerated particles as the inorganic filler, and includes an epoxy compound and a benzoxazine compound as the thermosetting resin, and
the thermally conductive resin sheet has a glass transition temperature of 160°C or higher and lower than 250°C.

[16] A sixteenth mode of the present invention is a thermally conductive resin sheet composed of a cured product of a thermosetting resin composition containing a thermosetting resin and an inorganic filler, wherein

the thermally conductive resin sheet includes boron nitride agglomerated particles as the inorganic filler, and includes an epoxy compound and a benzoxazine compound as the thermosetting resin, and
the thermally conductive resin sheet has an average coefficient thermal expansion from 0°C to 175°C of 20 ppm or more and 30 ppm or less.

[17] A seventeenth mode of the present invention is the thermally conductive resin sheet according to any one of the fourteenth to sixteenth modes, which has a thermal conductivity in the thickness direction at 25°C of 10 W/mK or more.
[18] An eighteenth mode of the present invention is a heat-dissipating laminated body including the thermally conductive resin sheet of any one of the fourteenth to seventeenth modes.
[19] A nineteenth mode of the present invention is a heat-dissipating circuit board including the thermally conductive resin sheet of any one of the fourteenth to seventeenth modes.
[20] A twentieth mode of the present invention is a semiconductor device including the heat-dissipating circuit board of the nineteenth mode.
[21] A twenty-first mode of the present invention is a power module including the thermally conductive resin sheet of any one of the fourteenth to seventeenth modes.

## Advantageous Effects of Invention

The thermosetting resin composition proposed by the present invention can be formed into a film without any problem when forming a sheet. Further, when cured, a thermally conductive sheet having thermal conductivity and heat resistance can be formed. In addition, sufficient adhesive strength can be obtained when cured.
Therefore, a heat-dissipating laminated body, a heat-dissipating circuit board, a semiconductor device, a power module, and the like can be suitably formed using the thermally conductive resin sheet.

## Brief Description of Drawing

[Figure 1] Figure 1 is a schematic diagram of a particle cross-sectional view of an example of boron nitride agglomerated particles having a card-house structure.

## Description of Embodiments

An example of embodiments of the present invention will be described in detail below. However, the present invention is not limited to the following embodiments, and can be modified in various ways without departing from the spirit of the present invention.

<<Subject thermosetting resin compositions

A thermosetting resin composition according to one example of the embodiments of the present invention (referred to as "subject thermosetting resin composition") is a thermosetting resin composition containing a thermosetting resin and an inorganic filler, wherein the thermosetting resin composition includes boron nitride agglomerated particles as the inorganic filler, and includes an epoxy compound and a benzoxazine compound as thermosetting resin components.
In the present invention, "thermosetting resin composition" means a composition containing a resin that is curable by heat. In other words, it suffices that the resin composition has a degree of curing that leaves room for curing by heat. Thus, the resin composition may have already been cured to a state that leaves room for further curing (also referred to as "preliminarily cured"), or may be in a state of not yet having been cured (referred to as "uncured").
The subject thermosetting resin composition may be in the form of a powder, a slurry, a liquid, a solid, or a molded article such as a sheet.
The subject thermosetting resin composition can be formed into a sheet-like thermosetting resin composition (also referred to as a "thermosetting resin sheet"), and by curing this thermosetting resin sheet, a resin sheet having thermal conductivity (hereinafter referred to as "subject thermally conductive resin sheet") can be formed. That is, the subject thermally conductive resin sheet is a cured product of the thermosetting resin sheet.
When the subject thermosetting resin composition is cured, the cured composition does not only have a crosslinked structure formed by an epoxy compound and a crosslinked structure formed by a benzoxazine compound, but those crosslinked structures also form a composite structure, resulting in a stronger crosslinked structure, so that a higher glass transition temperature (Tg) and better heat resistance can be obtained.
Further, since the subject thermosetting resin composition contains boron nitride agglomerated particles as an inorganic filler, a thermally conductive sheet having excellent thermal conductivity can be provided by curing.
In addition, as will be described later, by further including a polymer having a mass average molecular weight of 10,000 or more, even if the content proportion of boron nitride agglomerated particles is increased, handling properties can be improved and film forming properties can be improved.

<Thermosetting resin components>

The subject thermosetting resin composition includes an epoxy compound and a benzoxazine compound as thermosetting resin components.
Epoxy compounds and benzoxazine compounds are both compounds that crosslink and cure when heated. Further, the hydroxyl group that is generated when the benzoxazine compound is crosslinked reacts and bonds with the epoxy group of the epoxy compound, and thus the epoxy compound and the benzoxazine compound are combined together. As a result, the crosslinked structure created by the epoxy compound and the crosslinked structure created by the benzoxazine compound form a composite structure, enabling a stronger crosslinked structure to be obtained, and thus the glass transition temperature (Tg) of the subject thermosetting resin composition and the subject thermally conductive resin sheet can be increased.
The content of thermosetting resin is preferably from 5 to 99% by mass with respect to 100% by mass of the solid content excluding the inorganic filler from the subject thermosetting resin composition.
The content of the thermosetting resin is preferably 5% by mass or more because moldability is improved. On the other hand, the content is preferably 99% by mass or less because this ensures that other components can be contained, and thermal conductivity can be increased.
From this viewpoint, the content of the thermosetting resin is, with respect to 100% by mass of the solid content excluding the inorganic filler from the subject thermosetting resin composition, preferably from 5 to 99% by mass, and more preferably, of that, 10% by mass or more, of that, 20% by mass or more, of that, 300 by mass or more, of that, 40% by mass or more, and, of that, 50% by mass or more. It is more preferable to contain the thermosetting resin in a proportion of 98% by mass or less.
The subject thermosetting resin composition is allowed to include a thermosetting resin other than the epoxy compound and the benzoxazine compound.
Examples of the other thermosetting resin include a phenol resin, a polycarbonate resin, an unsaturated polyester resin, a urethane resin, a melamine resin, and a urea resin.
However, it is preferable that the epoxy compound and the benzoxazine compound account for from 30 to 1000 by mass of the thermosetting resin included in the subject thermosetting resin composition, and it is more preferable that the epoxy compound and the benzoxazine compound account for, of that, 40% by mass or more, of that, 50% by mass or more, of that, 60% by mass, and of that, 70% by mass or more.

(Epoxy compound)

The epoxy compound as the thermosetting resin included in the subject thermosetting resin composition may be any compound having one or more oxirane rings (epoxy groups) in one molecule.
The oxirane ring (epoxy group) included in the epoxy compound may be either an alicyclic epoxy group or a glycidyl group. From the viewpoint of reaction rate or heat resistance, a glycidyl group is more preferable.
Examples of the epoxy compound include an epoxy group-containing silicon compound, an aliphatic epoxy resin, a bisphenol A-type or F-type epoxy resin, a novolak epoxy resin, an alicyclic epoxy resin, a glycidyl ester epoxy resin, a polyfunctional epoxy resin, and a polymeric epoxy resin.
The epoxy compound may be a compound containing an aromatic oxirane ring (epoxy group). Specific examples include a bisphenol-type epoxy resin obtained by glycidylation of a bisphenol such as bisphenol A, bisphenol F, bisphenol AD, bisphenol S, tetramethylbisphenol A, tetramethylbisphenol F, tetramethylbisphenol AD, tetramethylbisphenol S, and tetrafluorobisphenol A, a biphenyl type epoxy resin, an epoxy resin obtained by glycidylation of a dihydric phenol such as dihydroxynaphthalene and 9,9-bis(4-hydroxyphenyl)fluorene, an epoxy resin obtained by glycidylation of a trisphenol such as 1,1,1-tris(4-hydroxyphenyl)methane, an epoxy resin obtained by glycidylation of a tetrakisphenol such as 1,1,2,2-tetrakis(4-hydroxyphenyl)ethane, and a novolak-type epoxy resin obtained by glycidylation of a novolak such as phenol novolak, cresol novolak, bisphenol A novolak, and brominated bisphenol A novolak.

[Polyfunctional epoxy compound]

It is particular preferable that the epoxy compound included in the subject thermosetting resin composition include the polyfunctional epoxy compound described below.
As used herein, "polyfunctional epoxy compound" refers to an epoxy compound having two or more oxirane rings (epoxy groups) in one molecule and a mass average molecular weight of less than 10,000.
Adding such a polyfunctional epoxy compound makes it possible to introduce a highly polar oxirane ring (epoxy group) in a high density, thereby increasing the effects of physical interactions such as van der Waals forces and hydrogen bonds. For example, the adhesion between the subject thermally conductive resin sheet formed from the subject thermosetting resin composition and a conductor can be improved. In addition, by adding the polyfunctional epoxy compound, the storage modulus of the subject thermally conductive resin sheet can be increased, which allows a strong anchor effect to develop and the adhesion between the subject thermally conductive resin sheet and the conductor to be improved after a cured product of the subject thermosetting resin composition has penetrated into irregularities on the surface of the conductor, which is an adherend.
On the other hand, by introducing the polyfunctional epoxy compound, the hygroscopicity of the subject thermosetting resin composition tends to increase, but by improving the reactivity of the oxirane ring (epoxy group), the amount of hydroxyl groups during the reaction can be reduced, which allows the increase in hygroscopicity to be suppressed. Further, by combining the above-described high molecular weight epoxy resin and polyfunctional epoxy compound to produce the subject thermosetting resin composition, it becomes possible for the subject thermally conductive resin sheet to achieve both high elasticity and low moisture absorption.
From the viewpoint of increasing the storage modulus of the cured product after thermosetting, in particular the storage modulus at high temperatures, which is important in cases such as power semiconductors that generate a large amount of heat, it is sufficient that the polyfunctional epoxy compound be an epoxy compound having two or more oxirane rings (epoxy groups) in one molecule, and of those, an epoxy compound having three or more oxirane rings (epoxy groups) in one molecule is preferable, and an epoxy compound having four or more glycidyl groups is much more preferable. By having a plurality of oxirane rings (epoxy groups), in particular glycidyl groups, in one molecule, the crosslinking density of the cured product is improved, and the subject thermally conductive resin sheet, which is the cured product obtained, has a higher strength. As a result, when internal stress occurs in the subject thermally conductive resin sheet during a moisture absorption reflow test, the subject thermally conductive resin sheet retains its shape without deforming or breaking, and thus it is possible to suppress the generation of gaps such as voids in the subject thermally conductive resin sheet.
Further, from the viewpoint of increasing the storage modulus of the subject thermally conductive resin sheet after thermosetting, the molecular weight of the polyfunctional epoxy compound is preferably 650 or less, in particular is 100 or more or 630 or less, and more preferably, of that, 200 or more or 600 or less. Further, in order to improve the handling properties of the sheet, it is preferable to include a polyfunctional epoxy compound that is liquid at 25°C.
In addition, from the viewpoint of achieving lower moisture absorption and higher crosslinking, it is preferable not to include an amine-based or amide-based structure containing a nitrogen atom.
As a specific example of the polyfunctional epoxy compound, for example, a polyfunctional epoxy compound having three or more epoxy groups per molecule and having a molecular weight of 650 or less is preferable. For example, EX321L, DLC301, DLC402, and the like, manufactured by Nagase ChemteX can be used.
These polyfunctional epoxy compounds may be used alone or in combination of two or more.

The content of the polyfunctional epoxy compound is preferably 5% by mass or more and 80% by mass or less with respect to 100% by mass of the solid content excluding the inorganic filler from the subject thermosetting resin composition.

The content of the polyfunctional epoxy compound is preferably 5% by mass or more because the elastic modulus of the cured product of the thermosetting resin composition can be maintained, and is preferably 80% by mass or less because the coefficient of water absorption does not become too high.

From this viewpoint, the content of the polyfunctional epoxy compound is preferably 5% by mass or more and 80% by mass or less with respect to 100% by mass of the solid content excluding the inorganic filler from the subject thermosetting resin composition.

Further, in particular for a polyfunctional epoxy compound having three or more epoxy groups per molecule and having a molecular weight of 650 or less, the content of the polyfunctional epoxy compound is preferably 5% by mass or more and 75% by mass or less with respect to 1000 by mass of the solid content excluding the inorganic filler from the subject thermosetting resin composition, of that, preferably 10% by mass or more or 70% by mass or less, and more preferably, of that, 15% by mass or more or 50% by mass or less.

As will be described later, when a high molecular weight epoxy resin and a polyfunctional epoxy compound are used together, from the viewpoint of the film formability of the sheet and the elastic modulus of the sheet cured product, the content of the polyfunctional epoxy compound is, with respect to a content of 100 parts by mass of the high molecular weight epoxy resin, preferably 20 parts by mass or more and 500 parts by mass or less, and more preferably, of that, 30 parts by mass or more or 400 parts by mass or less, of that, 40 parts by mass or more or 350 parts by mass or less.

(Benzoxazine compound)

The benzoxazine compound preferably has a structure represented by the following formula (I) or formula (II).

[C1]

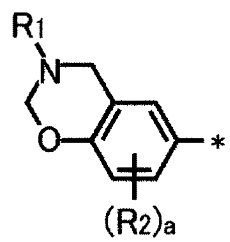

Formula (I)

[C2]

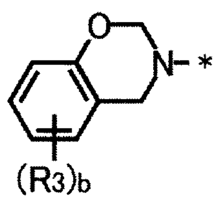

Formula (II)

In formula (I), a represents an integer of 0 to 3, and $R_1$ and $R_2$ each independently represent a hydrogen atom or a monovalent organic group.

Specific examples of $R_1$ include a hydrogen atom, an alkyl group, an alkenyl group, a cycloalkyl group, an aryl group, an aralkyl group, an alkynyl group, and the like. $R_1$ may be substituted with any substituent.

Specific examples of $R_2$ include an aliphatic hydrocarbon group and an aromatic hydrocarbon group. a is preferably 0 or 1, more preferably 0.

* means a bond with another chemical structure.

In formula (II), b represents an integer of 0 to 4, and $R_3$ represents a hydrogen atom or a monovalent organic group. When b is 2 or more, a plurality of $R_3$ may be the same or different.

Specific examples of $R_3$ include an aliphatic hydrocarbon group and an aromatic hydrocarbon group. b is preferably 0 or 1, more preferably 0.

* means a bond with another chemical structure.

The benzoxazine compound preferably has a plurality of structures represented by formula (I) and/or formula (II) in one molecule. More specifically, the benzoxazine compound preferably has 2 to 4, and more preferably 2, structures represented by formula (I) and/or formula (II) in one molecule. It is thought that by using such a compound, curing performance can be further enhanced and heat resistance will also be improved.

The benzoxazine compound preferably includes a benzoxazine compound represented by formula (III). The benzoxazine compound represented by formula (III) is often also called a Pd-type benzoxazine.

[C3]

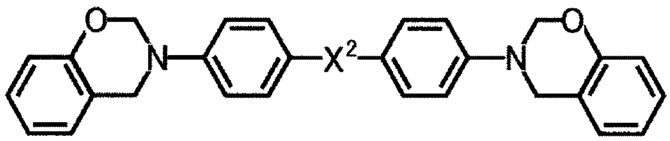

Formula (III)

In formula (III), $X^2$ is a single bond or a divalent linking group.

More specifically, $X^2$ can be a single bond, a linear or branched alkylene group having from 1 to 10 carbon atoms, -O-, $-SO_2-$, -CO-, a structure in which two or more of these are connected, and the like.

The benzoxazine compound may include a benzoxazine compound represented by formula (IV). Incidentally, the benzoxazine compound represented by formula (IV) is often also called Fa-type benzoxazine.

In formula (IV), the definition and specific examples of $X^2$ are the same as those for $X^2$ in formula (III) .

[C4]

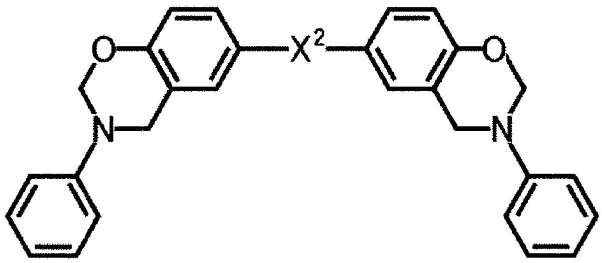

Formula (IV)

Some benzoxazine compounds are solid at 25°C and some are liquid. Whether solid or liquid, setting the mass proportion of the boron nitride agglomerated particles to the benzoxazine compound (boron nitride agglomerated particles/benzoxazine) to 5 or more and 50 or less has the effect of increasing the adhesive strength with the base material upon curing.

From the viewpoint of increasing the glass transition temperature (Tg) and the heat resistance of the subject thermosetting resin composition and a cured product thereof, it is more preferable that the subject thermosetting resin composition is solid at 25°C.

On the other hand, from the viewpoint of enhancing the film forming properties of the subject thermosetting resin composition and cured product thereof to increase adhesive properties, it is more preferable that the subject thermosetting resin composition is liquid at 25°C.

In this case, being "liquid at 25°C" means that the viscosity at 25°C is 150,000 mPa·s or less, preferably 100,000 mPa·s or less, more preferably 50,000 mPa·s or less, and further preferably 10,000 mPa·s or less.

When the subject thermosetting resin composition contains a benzoxazine compound that is liquid at 25°C, even if the proportion of boron nitride agglomerated particles is increased, the handling properties can be improved, the film forming properties can be enhanced, and the adhesive strength with the base material when cured can be further increased.

The benzoxazine compound that is liquid at 25°C preferably includes a benzoxazine compound represented by formula (V).

[C5]

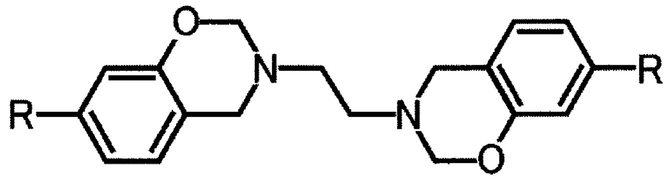

Formula (V)

In formula (V), each R may independently be an aliphatic hydrocarbon group or an aromatic hydrocarbon group, and an aliphatic hydrocarbon group is particularly preferred from the viewpoint of flexibility.

The content of the benzoxazine compound is, with respect to 100% by mass of the solid content excluding the inorganic filler from the subject thermosetting resin composition, preferably 3% by mass or more and 50% by mass or less, and more preferably, of that, 5% by mass or more or 30% by mass or less, and of that, 8% by mass or more or 25% by mass or less.

Further, the content of the benzoxazine compound that is liquid at 25°C is, with respect to 100% by mass of the solid content excluding the inorganic filler from the subject thermosetting resin composition, preferably 2% by mass or more and 50% by mass or less, and more preferably, of that, 3% by mass or more or 30% by mass or less, and of that, 5% by mass or more or 25% by mass or less.

(Proportion of boron nitride agglomerated particles to benzoxazine compound)

The mass proportion of the boron nitride agglomerated particles to the benzoxazine compound (boron nitride agglomerated particles/benzoxazine) is, from the viewpoint of obtaining sufficient adhesive strength (peel strength), preferably 50 or less, more preferably 40 or less, further preferably 30 or less, and most preferably 20 or less. On the other hand, from the viewpoint of thermosetting properties, the mass proportion is preferably 5 or more, more preferably 7 or more, and further preferably 10 or more.

(Content proportion of epoxy compound to benzoxazine compound)

If the proportion of the benzoxazine compound is increased, the film may become brittle and film formability may decrease. Therefore, the content of the benzoxazine compound in the subject thermosetting resin composition is preferably lower than the content of the epoxy compound. Of that, the mass ratio of the content of the benzoxazine compound with respect to the content of the epoxy compound in the solid content excluding the inorganic filler from the subject thermosetting resin (benzoxazine compound/epoxy compound) is preferably less than 0.8, and more preferably, of that, 0.7 or less, of that, 0.6 or less, of that, 0.5 or less. On the other hand, from the viewpoint of improving the adhesive properties, the mass ratio is preferably 0.075 or more, and more preferably, of that, 0.08 or more, and of that, 0.1 or more.

By setting the content of the benzoxazine compound in the above range, film formability is excellent, the curing reaction of the thermosetting resin proceeds appropriately, and the obtained thermally conductive resin sheet has heat resistance and adhesive properties.

<Inorganic filler>

The inorganic filler contained in the subject thermosetting resin composition preferably has a thermal conductivity of 2.0 W/m·K or more, particularly 3.0 W/m·K or more, particularly 5.0 W/m·K or more, and particularly more preferably 10.0 W/m·K or more.

Examples of the inorganic filler include fillers having electrical insulation properties that are composed only of carbon, fillers composed of a metal carbide or a metalloid carbide, metal oxide or metalloid oxide, metal nitride or metalloid nitride, and the like.

Examples of fillers having electrical insulation properties that are composed only of carbon include diamond (thermal conductivity: approximately 2000 W/m·K).

Examples of the metal carbide or metalloid carbide include silicon carbide (thermal conductivity: approximately

60 to 270 W/m·K), titanium carbide (thermal conductivity: approximately 21 W/m.K), and tungsten carbide (thermal conductivity: approximately 120 W/m·K).

Examples of the metal oxide or metalloid oxide include magnesium oxide (thermal conductivity: approximately 40 W/m.K), aluminum oxide (thermal conductivity: approximately 20 to 35 W/m.K), zinc oxide (thermal conductivity: approximately 54 W/m.K), yttrium oxide (thermal conductivity: approximately 27 W/m.K), zirconium oxide (thermal conductivity: approximately 3 W/m.K), ytterbium oxide (thermal conductivity: approximately 38.5 W/m-K), beryllium oxide (thermal conductivity: approximately 250 W/m·K) , and "SiAlON" (ceramic made of silicon, aluminum, oxygen, and nitrogen, thermal conductivity: approximately 21 W/m·K).

Examples of the metal nitride or metalloid nitride include boron nitride (thermal conductivity in the plane direction of plate-like particles of hexagonal boron nitride (h-BN) : approximately 200 to 500 W/m·K), aluminum nitride (thermal conductivity: approximately 160 to 285 W/m·K), and silicon nitride (thermal conductivity: approximately 30 to 80 W/m·K) .

These inorganic fillers may be used alone or in combination of two or more.

From the viewpoint of electrical insulation properties, the volume resistivity of the inorganic filler at 20°C is preferably $10^{13}$ $\Omega$·cm or more, and in particular $10^{14}$ $\Omega$·cm or more is more preferable. Among the above, a metal oxide, a metalloid oxide, a metal nitride, or a metalloid nitride is preferable from the viewpoint of easily achieving sufficient electrical insulation properties of the subject thermally conductive resin sheet. Specific examples of such inorganic fillers include aluminum oxide ($Al_2O_3$, volume resistivity: >$10^{14}$ Qcm), aluminum nitride (AlN, volume resistivity: >$10^{14}$ $\Omega$cm), boron nitride (BN, volume resistivity: >$10^{14}$ Qcm) silicon nitride ($Si_3N_4$, volume resistivity: >$10^{14}$ $\Omega$·cm), and silica ($SiO_2$, volume resistivity: >$10^{14}$ $\Omega$·cm).

Of those, aluminum oxide, aluminum nitride, and boron nitride are preferred, and aluminum oxide and boron nitride are particularly preferred since they can impart high insulation properties to the subject thermally conductive resin sheet.

The inorganic filler may have an indefinite particle shape, a spherical shape, a whisker shape, a fiber shape, a plate shape, an agglomerate shape, or a shape of a mixture thereof.

Of those, the shape of the inorganic filler of the present invention is preferably spherical.

In addition, as used herein, "spherical" usually means a shape having an aspect ratio (ratio of major axis to minor axis) of 1 or more and 2 or less, preferably 1 or more and 1.75 or less, more preferably 1 or more and 1.5 or less, and further preferably 1 or more and 1.4 or less.

The aspect ratio is determined by arbitrarily selecting 10 or more particles from an image of a cross section of the subject thermosetting resin composition or subject thermally conductive resin sheet photographed with a scanning electron microscope (SEM), determining the ratio of the major axis to the minor axis of each particle, and calculating the average value.

[Boron nitride agglomerated particles]

The inorganic filler included in the subject thermosetting resin composition preferably contains "boron nitride agglomerated particles" each formed by agglomeration of primary particles of boron nitride from the viewpoint that there are fewer problems with moisture absorption during heat molding, toxicity is lower, thermal conductivity can be efficiently increased, and has high insulation properties can be imparted to the subject thermally conductive resin sheet.

Further, the boron nitride agglomerated particles may be used together with another inorganic filler. However, the heat transfer behavior in the subject thermally conductive resin sheet does not only depend on the thermal conductivity inside the inorganic filler, as described later. Therefore, among the particles exemplified above, even if diamond particles or the like, which have extremely high thermal conductivity but are also extremely expensive, are used, the thermal conductivity in the thickness direction of the subject thermally conductive resin sheet does not increase significantly. Accordingly, when boron nitride agglomerated particles are used in combination with another inorganic filler, the main focus is on reducing the cost of the composition. Therefore, it is preferable to appropriately select the inorganic filler to be used in combination with boron nitride from among magnesium oxide, aluminum oxide, tungsten carbide, silicon carbide, aluminum nitride, and the like, since those materials are relatively inexpensive and have relatively high thermal conductivity.

From the viewpoint of high thermal conductivity, the boron nitride agglomerated particles preferably account for 75% by mass or more of the inorganic filler, and of that, boron nitride agglomerated particles account for more preferably 80% by mass or more, and of that, 850 by mass or more (including 100% by mass).

The shape of the boron nitride agglomerated particles is preferably spherical.

The agglomerated structure of the boron nitride agglomerated particles is preferably a card-house structure from the viewpoint of improving thermal conductivity. Therefore, it is preferable that the boron nitride agglomerated particles include boron nitride agglomerated particles having a card-house structure. That is, the agglomerated structure of the boron nitride agglomerated particles may have a structure other than the card-house structure. However, at this stage, it is preferable to have an agglomerated structure of boron nitride agglomerated particles.

The agglomerated structure of the boron nitride agglomerated particles can be confirmed using a scanning electron microscope (SEM).

A card-house structure is a structure in which plate-shaped particles are laminated in a complicated manner without orientation, and is described in "Ceramics 43 No. 2" (2008, published by the Ceramic Society of Japan).

More specifically, a card-house structure is a structure in which a flat surface of the primary particles forming an agglomerated particle is in contact with the end surface of another primary particle existing within the agglomerate particle. A schematic diagram of the card-house structure is shown in Figure 1.

Such agglomerated particles having a card-house structure have an extremely high breaking strength due to their structure, and do not collapse even in the pressurizing process performed during sheet forming of the subject thermally conductive resin sheet. Therefore, the primary particles, which are normally oriented in the longitudinal direction of the subject thermally conductive resin sheet, can be made to exist in random directions. Therefore, when agglomerated particles having a card-house structure are used, it is possible to further increase the proportion of the ab-plane of the primary particles oriented in the thickness direction of the subject thermally conductive resin sheet. As a result, heat can be effectively conducted in the thickness direction of the sheet, and thermal conductivity in the thickness direction can be further enhanced.

In addition, the boron nitride agglomerated particles having a card-house structure can be produced by, for example, the method described in International Publication No. WO 2015/119198.

When using boron nitride agglomerated particles having a card-house structure, the particles may be surface-treated with a surface treatment agent.

As the surface treatment agent, for example, a known surface treatment agent used in a silane coupling treatment and the like can be used. Generally, there is often no direct affinity or adhesion between the inorganic filler and the thermosetting resin, and this is also the case when boron nitride agglomerated particles having a card-house structure are used as the inorganic filler. It is thought that by increasing the adhesion at the interface of the inorganic filler and the matrix resin through a chemical treatment, it is possible to further reduce thermal conductivity attenuation at the interface.

By using boron nitride agglomerated particles as the inorganic filler used in the subject thermally conductive resin sheet, the particle size can be increased compared to an inorganic filler that uses primary particles as they are.

By increasing the particle size of the inorganic filler, the heat transfer path through the inorganic filler via the thermosetting resin having a low thermal conductivity can be reduced, and therefore an increase in thermal resistance in the heat transfer path in the thickness direction can be reduced.

From the above viewpoint, the lower limit of the maximum particle size of the boron nitride agglomerated particles is preferably 20 μm or more, more preferably 30 μm or more, and further preferably 40 μm or more. On the other hand, the upper limit of the maximum particle size is preferably 300 μm or less, more preferably 200 μm or less, further preferably 100 μm or less, and still further preferably 90 μm or less.

Further, the average particle size of the boron nitride agglomerated particles is not particularly limited. Among that, the average particle size is preferably 5 μm or more, more preferably 10 μm or more, and in particular is further preferably 15 μm or more. In addition, the average particle size is preferably 100 μm or less, and more preferably 90 μm or less. By setting the average particle size of the boron nitride agglomerated particles to 5 μm or more, the number of particles in the resin composition and a cured product using the resin composition is relatively small. As a result, the number of interfaces between particles is reduced, and so thermal resistance decreases, and the composite resin sheet may have a high thermal conductivity. Moreover, by setting the average particle size to be equal to or less than the above upper limit value, the surface of a cured product using the resin composition tends to be smooth.

By setting the average particle size or maximum particle size of the boron nitride agglomerated particles to be equal to or less than the above upper limit, a high-quality film without surface roughness can be formed when the boron nitride agglomerated particles are included in the matrix resin. By setting the average particle size or maximum particle size to be equal to or more than the above lower limit, there are fewer interfaces between the matrix resin and the boron nitride agglomerated particles, and as a result thermal resistance is decreased, a high thermal conductivity can be achieved, and a sufficient effect of improving thermal conductivity as an inorganic filler, which is required for power semiconductor devices, can be obtained.

Further, the influence of the thermal resistance at the interface between the matrix resin and the boron nitride agglomerated particles on the thickness of the subject thermally conductive resin sheet is thought to become significant when the size of the boron nitride agglomerated particles relative to the thickness of the subject thermally conductive resin sheet is 1/10 or less. In particular, in the case of a power semiconductor device, in many cases the subject thermally conductive resin sheet that is used will have a thickness of from 100 μm to 300 μm, and so from the viewpoint of thermal conductivity, the maximum particle size of the boron nitride agglomerated particles is preferably larger than the above lower limit.

In addition, by setting the maximum particle size of the boron nitride agglomerated particles to be equal to or more than the above lower limit, not only is the increase in thermal resistance caused by the interface between the boron nitride agglomerated particles and the matrix resin suppressed, but also the number of required heat conduction paths

decreases, and the probability of linkages from one surface to another surface in the thickness direction of the subject thermally conductive resin sheet increases.

On the other hand, by setting the maximum particle size of the boron nitride agglomerated particles to equal to or less than the above upper limit, protrusion of the boron nitride agglomerated particles onto the surface of the subject thermally conductive resin sheet is suppressed, and a good surface shape without surface roughness can be obtained. As a result, when producing a sheet laminated with a copper substrate, the sheet has sufficient adhesion and excellent withstand voltage characteristics can be obtained.

The ratio (maximum particle size/thickness) of the size (maximum particle size) of the boron nitride agglomerated particles to the thickness of the subject thermally conductive resin sheet is preferably 0.2 or more and 1.0 or less, and more preferably, of that, 0.3 or more or is 0.95 or less, and of that, 0.3 or more or 0.9 or less.

The maximum particle size and average particle size of the boron nitride agglomerated particles can be measured by, for example, the following method.

The maximum particle size and average particle size of the boron nitride agglomerated particles used as a raw material can be determined by measuring the particle size distribution of a sample obtained by dispersing the boron nitride agglomerated particles in a solvent, specifically, a sample in which the boron nitride agglomerated particles are dispersed in a pure water medium containing a dispersion stabilizer, using a laser diffraction/scattering particle size distribution analyzer, and then determining the maximum particle size Dmax and the average particle size D50 of the boron nitride agglomerated particles from the obtained particle size distribution.

Here, Dmax and D50 are the maximum particle size and cumulative volume 50% particle size in the volume-based particle size distribution obtained by a measurement using a laser diffraction scattering particle size distribution measurement method.

Further, the maximum particle size and average particle size can also be determined using a dry particle size distribution measuring device such as Morphologi G3 (manufactured by Malvern).

On the other hand, for the maximum particle size and average particle size of the boron nitride agglomerated particles in the subject thermosetting resin composition or subject thermally conductive resin sheet as well, the maximum particle size Dmax and the average particle size D50 can be measured using the same method as above by dissolving and removing the thermosetting resin in a solvent (including a heating solvent), or, by making the thermosetting resin swell in order to reduce the adhesion strength with the boron nitride agglomerated particles, then physically removing the thermosetting resin and further heating the resin component in the air for ashing and removal.

Regarding the maximum particle size of the boron nitride agglomerated particles in the subject thermosetting resin composition or subject thermally conductive resin sheet, it is also possible to determine the maximum particle size by directly observing a cross section of ten or more freely-selected boron nitride agglomerated particles in the subject thermosetting resin composition or subject thermally conductive resin sheet using a scanning electron microscope, a transmission electron microscope, a Raman spectrometer, and an atomic force microscope, or the like.

Further, it is also possible to determine the average particle size of the boron nitride agglomerated particles in the subject thermosetting resin composition or subject thermally conductive resin sheet by directly observing a cross section of ten or more freely-selected boron nitride agglomerated particles in the subject thermosetting resin composition or subject thermally conductive resin sheet using a scanning electron microscope, a transmission electron microscope, a Raman spectrometer, and an atomic force microscope, or the like, and taking the arithmetic mean value of the diameters of the particles.

In addition, when a particle is non-spherical, the longest diameter and the shortest diameter are measured, and the average value thereof is taken as the particle size of the particle.

The breaking strength of the boron nitride agglomerated particles is preferably 20 MPa or less, more preferably, of that, 15 MPa or less, and further preferably, of that, 10 MPa or less.

By setting the breaking strength of the boron nitride agglomerated particles to 20 MPa or less, the portions where the boron nitride agglomerated particles are in contact with each other deform, and can make surface contact with each other. Therefore, while maintaining high thermal conductivity inside the boron nitride agglomerated particles, the contact thermal resistance at the interfaces of the boron nitride agglomerated particles and the interface between the metal substrate and the subject thermally conductive resin sheet, which will be described later, can be reduced, and the overall thermal conductivity can be improved.

However, if the breaking strength of the boron nitride agglomerated particles is too small, the particles will be easily broken by the pressure used to produce the molded article, and thermal conductivity tends not to improve. Therefore, the breaking strength of the boron nitride agglomerated particles is preferably 2.5 MPa or more, and more preferably, of that, 3.0 MPa or more, of that, 3.5 MPa or more, and of that, 4.0 MPa or more.

The breaking strength can be calculated using the following formula by subjecting one particle to a compression test according to JIS R 1639-5. Usually, the particle is measured at five or more points and taking the average value thereof.

$$\text{Formula: } Cs = 2.48\ P/\pi d^2$$

Cs: Breaking strength (MPa)
P: Destructive test force (N)
d: Particle size (mm)

The elastic modulus of the boron nitride agglomerated particles is preferably 48 MPa or more, and more preferably, of that, 50 MPa or more, and of that, 55 MPa or more.

If the elastic modulus of the boron nitride agglomerated particles is within the above range, it is possible to prevent the boron nitride agglomerated particles from plastically deforming in the direction of the press pressure and the agglomerated structure from collapsing. On the other hand, the upper limit value of the elastic modulus is not particularly limited. However, from the viewpoint of easily obtaining sufficient deformation, the elastic modulus of the boron nitride agglomerated particles is preferably 2000 MPa or less, more preferably 1500 MPa or less, and further preferably 1000 MPa or less.

The elastic modulus of the boron nitride agglomerated particles can be calculated using the following formula from the test force at the time of break and the compressive displacement at that time using the device used to measure the breaking strength.

$$E=3\times(1-\nu^2)\times P/4\times(d/2)^{1/2}\times Y^{3/2}$$

("E" is the elastic modulus (MPa), "ν" is Poisson's ratio, "P" is the destructive test force (N), "d" is the particle size (mm), and "Y" is the compressive displacement (mm). It is noted that Poisson's ratio can be assumed to be constant (0.13).)

(Content of inorganic filler)

From the viewpoint of increasing insulation properties and thermal conductivity, the content of the inorganic filler is, with respect to 100% by mass of the total solid content of the subject thermosetting resin composition, preferably 50% by mass or more, and more preferably, of that, 62% by mass or more, and of that, 65% by mass or more. On the other hand, from the viewpoint of maintaining handling properties and film forming properties, the content is preferably 85% by mass or less, more preferably 83% by mass or less, and further preferably 81% by mass or less.

From the viewpoint of increasing insulation properties and thermal conductivity, the content of the boron nitride agglomerated particles is, with respect to 100% by mass of the total solid content of the subject thermosetting resin composition, preferably 50% by mass or more, and more preferably, of that, 62% by mass or more, and of that, 65% by mass or more. On the other hand, from the viewpoint of maintaining handling properties and film forming properties, the content is preferably 85% by mass or less, more preferably, of that, 83% by mass or less, and further preferably, of that, 810 by mass or less.

<Polymer having molecular weight of 10,000 or more>

The subject thermosetting resin composition preferably contains a polymer having a mass average molecular weight of 10,000 or more.

By containing such a polymer, the subject thermosetting resin composition has better film forming properties even if the proportion of boron nitride agglomerated particles is increased.

The polymer may be either a thermoplastic resin or a thermosetting resin.

Examples of the thermoplastic resin and the thermosetting resin include thermoplastic resins such as polyphenylene ether, polyphenylene sulfide, polyarylate, polysulfone, polyether sulfone, polyether ether ketone, and polyether ketone. Further, as the thermoplastic resin and the thermosetting resin, a group of heat-resistant resins called "super engineering plastics", such as thermoplastic polyimide, thermosetting polyimide, benzoxazine, and a reaction product of polybenzoxazole and benzoxazine, can also be used. In addition, a styrenic polymer such as styrene and alkylstyrene; a (meth)acrylic polymer such as alkyl (meth)acrylate and glycidyl (meth)acrylate; a styrene-(meth)acrylic polymer such as styrene-glycidyl methacrylate; a polyvinyl alcohol derivative such as polyvinyl butyral, polyvinyl benzal, and polyvinyl acetal; a norbornene-based polymer containing a norbornene compound; and a phenoxy resin can also be used. Of those, a phenoxy resin is preferable in terms of heat resistance and compatibility with the thermosetting resin.

The thermoplastic resin and the thermosetting resin may each be used alone or in combination of two or more. Either of the thermoplastic resin or the thermosetting resin may be used, or the thermoplastic resin and the thermosetting resin may be used together.

The content of the polymer having a mass average molecular weight of 10,000 or more is, with respect to 100% by

mass of the solid content excluding the inorganic filler from the subject thermosetting resin composition, preferably 10% by mass or more and less than 30% by mass.

It is preferable to contain 10% by mass or more of the polymer due to maintaining retention force of the inorganic filler and film formability, and to contain the polymer in a proportion of less than 30% by mass due to maintaining strength during curing.

From this viewpoint, the content of the polymer is, with respect to 100% by mass of the solid content excluding the inorganic filler from the subject thermosetting resin composition, preferably 10% by mass or more, and more preferably, of that, 15% by mass or more, and of that, 20% by mass or more. On the other hand, the content is preferably less than 30% by mass, and more preferably, of that, less than 29% by mass.

Among those described above, the polymer preferably has a functional group that reacts with the above-described epoxy compound.

Here, examples of the functional group that reacts with the epoxy compound include, as a functional group that reacts with an epoxy group, a phenolic hydroxyl group, an epoxy group, a carboxylic acid group, a carboxylic anhydride group, and an active ester.

From the viewpoint of solubility in other resin components, preferable examples of such a polymer include the following high molecular weight epoxy resin.

(High molecular weight epoxy resin)

The high molecular weight epoxy resin may be any epoxy resin having a mass average molecular weight of 10,000 or more.

Examples of the high molecular weight epoxy resin include phenoxy resins having at least one skeleton selected from the group consisting of a bisphenol A type skeleton, a bisphenol F type skeleton, a bisphenol A/F mixed type skeleton, a naphthalene skeleton, a fluorene skeleton, a biphenyl skeleton, an anthracene skeleton, a pyrene skeleton, a xanthene skeleton, an adamantane skeleton, and a dicyclopentadiene skeleton.

Examples of the high molecular weight epoxy resin include an epoxy resin having at least one structure selected from the structure represented by the following structural formula (1) (hereinafter sometimes referred to as "structure (1)") and a structure represented by the following structural formula (2) (hereinafter sometimes referred to as "structure (2)").

[C6]

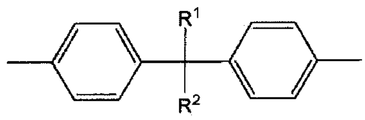

(1)

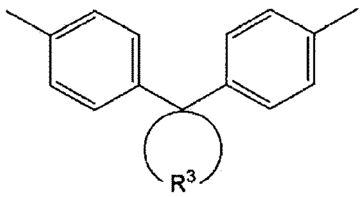

(2)

In structural formula (1), $R^1$ and $R^2$ each represent an organic group, and at least one of which is an organic group having a molecular weight of 16 or more. In structural formula (2), $R^3$ represents a divalent cyclic organic group.

As used herein, "organic group" includes any group containing a carbon atom. Specific examples include an alkyl group, an alkenyl group, and an aryl group. These may be substituted with a halogen atom, a group having a hetero group, and/or another hydrocarbon group. The same also applies below.

Further, examples of high molecular weight epoxy resins include an epoxy resin having a structure represented by the following structural formula (3) (hereinafter sometimes referred to as "structure (3)").

[C7]

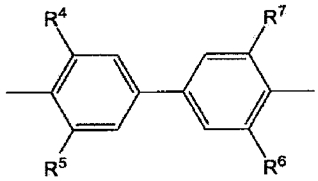

(3)

In structural formula (3), $R^4$, $R^5$, $R^6$, and $R^7$ each represent an organic group having a molecular weight of 15 or more.

In the above structural formula (1), at least one of $R^1$ and $R^2$ represents an organic group having a molecular weight of 16 or more, and preferably from 16 to 1000, for example an alkyl group such as an ethyl group, a propyl group, a butyl group, a pentyl group, a hexyl group, and a heptyl group, and an aryl group such as a phenyl group, a tolyl group, a xylyl group, a naphthyl group, and a fluorenyl group. $R^1$ and $R^2$ may both be organic groups having a molecular weight of 16 or more, or one of $R^1$ and $R^2$ may be an organic group having a molecular weight of 16 or more and the other may be an organic group having a molecular weight of 15 or less or a hydrogen atom. From the viewpoint of easily controlling handling properties such as resin viscosity, and the strength of cured product, preferably one of $R^1$ and $R^2$ is an organic group having a molecular weight of 16 or more and the other is an organic group having a molecular weight of 15 or less, and in particular, one of $R^1$ and $R^2$ is a methyl group and the other is a phenyl group.

In the above structural formula (2), $R^3$ is a divalent cyclic organic group, which may be an aromatic ring structure such as a benzene ring structure, a naphthalene ring structure, or a fluorene ring structure, or may be an aliphatic ring structure such as cyclobutane, cyclopentane, or cyclohexane. Further, these may independently have a substituent such as a hydrocarbon group or a halogen atom. The divalent bond may be a divalent group located on a single carbon atom or may be a divalent group located on different carbon atoms. Preferable examples include a divalent aromatic group having from 6 to 100 carbon atoms and a group derived from a cycloalkane having from 2 to 100 carbon atoms, such as cyclopropane and cyclohexane. In particular, from the viewpoint of easily controlling handling properties such as resin viscosity, and the strength of cured product, $R^3$ is preferably a 3,3,5-trimethyl-1,1-cyclohexylene group represented by the following structural formula (4) (hereinafter sometimes referred to as "structure (4)").

[C8]

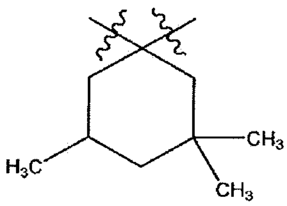

(4)

In the above structural formula (3), $R^4$, $R^5$, $R^6$, and $R^7$ each represent an organic group having a molecular weight of 15 or more. Preferably, $R^4$, $R^5$, $R^6$, and $R^7$ are each an alkyl group having a molecular weight of from 15 to 1000, and from the viewpoint of easily controlling handling properties such as resin viscosity, and the strength of cured product, it is particularly preferable that all of $R^4$, $R^5$, $R^6$, and $R^7$ are methyl groups.

The high molecular weight epoxy resin is particularly preferably an epoxy resin including any one of structures (1) and (2) and the structure (3) from the viewpoint of achieving both a reduction in moisture absorption and retaining the strength of the subject thermally conductive resin sheet, which is the obtained cured product.

This high molecular weight epoxy resin includes more hydrophobic hydrocarbons and aromatic structures than a general epoxy resin having a bisphenol A or bisphenol F skeleton, and so by adding the high molecular weight epoxy resin, the moisture absorption amount of the subject thermally conductive resin sheet, which is the obtained cured product, can be reduced.

Further, from the viewpoint of reducing the moisture absorption amount, it is preferable that the high molecular weight epoxy resin includes a large amount of the structures (1), (2), and (3), which are hydrophobic structure. Specifically, an epoxy resin having a mass average molecular weight of 10, 000 or more is preferable, an epoxy resin having a mass average molecular weight of 20,000 or more is more preferable, and an epoxy resin having a mass average molecular weight of 30,000 or more, for example from 30,000 to 80,000, is further preferable.

In addition, it is preferable that the high molecular weight epoxy resin is more hydrophobic, and from this viewpoint, a larger epoxy equivalent of the epoxy component is better. Specifically, 5,000 g/equivalent or more is preferable, and 7,000 g/equivalent or more, for example, from 8,000 to 15,000 g/equivalent, is more preferable.

The mass average molecular weight of the epoxy resin is a value measured by gel permeation chromatography in terms of polystyrene.

Further, epoxy equivalent is defined as "the mass of an epoxy resin containing 1 equivalent of epoxy groups", and can be measured in accordance with JIS K7236.

This high molecular weight epoxy resin may be used alone, or in combination of two or more.

The content of the high molecular weight epoxy resin is, with respect to 100% by mass of the solid content excluding the inorganic filler from the subject thermosetting resin composition, preferably 10% by mass or more and less than 30% by mass.

It is preferable to set the content of the high molecular weight epoxy resin to 10% by mass or more because the retention force of the inorganic filler and film formability can be maintained, and to set the content to less than 30% by mass because strength during curing can be maintained.

From this viewpoint, the content of the high molecular weight epoxy resin is, with respect to 100% by mass of the solid content excluding the inorganic filler from the subject thermosetting resin composition, preferably 10% by mass or more and less than 30% by mass, and more preferably, of that, 13% by mass or more or 29% by mass or less, and of that, 15% by mass or more or 28% by mass or less.

<Curing agent>

In the subject thermosetting resin composition, the benzoxazine compound also acts as a curing agent for the epoxy compound, but, if necessary, a compound other than benzoxazine can also be contained as a curing agent.

Examples of the curing agent include a phenol resin, a compound having a heterocyclic structure containing a nitrogen atom (hereinafter sometimes referred to as "nitrogen-containing heterocyclic compound"), an acid anhydride having an aromatic skeleton or an alicyclic skeleton, a hydrogenated product of such an acid anhydride, and a modified product of such an acid anhydride. These curing agents may be used alone or in combination of two or more.

By using these preferable curing agents, it is possible to obtain a resin cured product having an excellent balance among heat resistance, moisture resistance, and electrical properties.

Examples of the phenol resin include phenol novolak, o-cresol novolak, p-cresol novolak, t-butylphenol novolak, dicyclopentadiene cresol, polyparavinylphenol, bisphenol A type novolak, xylylene-modified novolak, decalin-modified novolak, poly(di-o-hydroxyphenyl) methane, poly(di-m-hydroxyphenyl)methane, and poly(di-p-hydroxyphenyl)methane. Among those, to further improve the flexibility and flame retardance of the subject thermosetting resin composition and subject thermally conductive resin sheet, and to improve the mechanical properties and heat resistance of the resin cured product, a novolak type phenol resin having a rigid main chain skeleton or a phenol resin having a triazine skeleton is preferable. Further, in order to improve the flexibility of the uncured thermosetting resin composition and the toughness of the resin cured product, a phenol resin having an allyl group is preferable.

Examples of the heterocyclic structure of the nitrogen-containing heterocyclic compound include a structure derived from imidazole, triazine, triazole, pyrimidine, pyrazine, pyridine, azole, and the like. An imidazole-based compound or a triazine-based compound is preferable from the viewpoint of the insulation properties of thermosetting resin composition and improved adhesion to metals.

Examples of preferable imidazole-based compounds and triazine compounds include 2-ethyl-4-methylimidazole, 2-phenylimidazole, 1-benzyl-2-methylimidazole, 1-benzyl-2-phenylimidazole, 1-cyanoethyl-2-undecylimidazole, 1-cyanoethyl-2-ethyl-4-methylimidazole, 2-phenyl-4-methylimidazole, 1-cyanoethyl-2-phenylimidazolium trimellitate, 2,4-diamino-6-[2'-methylimidazolyl-(1')]-ethyl-s-triazine, 2,4-diamino-6-[2'-undecylimidazolyl-(1')]-ethyl-s-triazine, 2,4-diamino-6-[2'-ethyl-4'methylimidazolyl-(1'))]-ethyl-s-triazine, a 2,4-diamino-6-[2'-methylimidazolyl-(1')]-ethyl-s-triazine isocyanuric acid adduct, a 2-phenylimidazole isocyanuric acid adduct, 2-phenyl-4,5-dihydroxymethylimidazole, 2-phenyl-4-methyl-5-hydroxymethylimidazole, 2,4-diamino-6-vinyl-s-triazine, a 2,4-diamino-6-vinyl-s-triazine isocyanuric acid adduct, 2,4-diamino-6-methacryloyloxyethyl-s-triazine, and a 2,4-diamino-6-methacryloyloxyethyl-s-triazine isocyanuric acid adduct.

Among those, in particular, a compound having a structure derived from imidazole and a compound having a structure derived from triazine are preferable, and a compound having a structure derived from triazine is particularly preferable because such a compound has high resin compatibility and a high reaction activation temperature, which enables the curing rate and the physical properties after curing to be easily adjusted, and so as a result even further improvements can be made in the storage stability of the subject thermosetting resin composition and the adhesive strength after heat molding. The heterocyclic structure of the nitrogen-containing heterocyclic compound is particularly preferably a structure derived from 1,3,5-triazine. Further, it is also possible to have a plurality of the structural moieties exemplified above.

Depending on the structure, the nitrogen-containing heterocyclic compound may contain a curing catalyst, which will be described later. Therefore, the subject thermosetting resin composition can contain the nitrogen-containing heterocyclic compound as a curing catalyst.
The nitrogen-containing heterocyclic compound may be used alone or in combination of two or more. Further, one molecule may have a plurality of heterocyclic structures at the same time.
The molecular weight of the nitrogen-containing heterocyclic compound is preferably 1,000 or less, and more preferably 500 or less.
The acid anhydride having an aromatic skeleton, hydrogenated product of such an acid anhydride, or modified product of such an acid anhydride are not particularly limited.
The acid anhydride having an alicyclic skeleton, hydrogenated product of such an acid anhydride, or modified product of such an acid anhydride is preferably an acid anhydride having a polyalicyclic skeleton, a hydrogenated product of such an acid anhydride, or a modified product of such an acid anhydride, or is preferably an acid anhydride having an alicyclic skeleton obtained by an addition reaction between a terpene compound and maleic anhydride, a hydrogenated product of such an acid anhydride, or a modified product of such an acid anhydride.
The content of the curing agent is preferably from 0 to 70% by mass, and particularly from 0 to 55% by mass, with respect to 100% by mass of the solid content excluding the inorganic filler from the subject thermosetting resin composition. By setting the content of the curing agent to be equal to or more than the above lower limit, sufficient curing performance can be obtained, and by setting the content to be equal to or less than the above upper limit, the reaction can proceed effectively, the crosslinking density can be improved, the strength can be increased, and film forming properties are improved as well.

<Curing accelerator>

The subject thermosetting resin composition can optionally contain a curing catalyst as a curing accelerator in order to adjust the curing rate and the physical properties of the cured product if necessary.
It is preferable to appropriately select the curing catalyst depending on the thermosetting resin component and the type of curing agent.
Specific examples of the curing catalyst include a chain or cyclic tertiary amine, an organic phosphorus compound, a diazabicycloalkene such as a quaternary phosphonium salt or an organic acid salt, and an imidazole. Further, an organic metal compound, a quaternary ammonium salt, a metal halide, and the like can also be used. Examples of the organometallic compound include zinc octylate, tin octylate, and an aluminum acetylacetone complex. These may be used alone or in combination of two or more.
Among those, particularly from the viewpoint of storage stability, heat resistance, and curing rate, a compound containing an imidazole (referred to as "imidazole-based compound") is preferable.
Examples of preferable imidazole-based compounds include 2-ethyl-4-methylimidazole, 2-phenylimidazole, 1-benzyl-2-methylimidazole, 1-benzyl-2-phenylimidazole, 1-cyanoethyl-2-undecylimidazole, 1-cyanoethyl-2-ethyl-4-methylimidazole, 2-phenyl-4-methylimidazole, 1-cyanoethyl-2-phenylimidazolium trimellitate, 2,4-diamino-6-[2'-methylimidazolyl-(1')]-ethyl-s-triazine, 2,4-diamino-6-[2'-undecylimidazolyl-(1')]-ethyl-s-triazine, 2,4-diamino-6-[2'-ethyl-4'methylimidazolyl-(1'))]-ethyls-triazine, a 2,4-diamino-6-[2'-methylimidazolyl-(1')]-ethyl-s-triazine isocyanuric acid adduct, a 2-phenylimidazole isocyanuric acid adduct, 2-phenyl-4,5-dihydroxymethylimidazole, and 2-phenyl-4-methyl-5-hydroxymethylimidazole.
In particular, by using an imidazole compound having a melting point of 100°C or higher, and more preferably 200°C or higher, a cured product having excellent storage stability and adhesion can be obtained. Further, from the viewpoint of adhesive properties, a curing catalyst that includes a nitrogen-containing heterocyclic compound other than an imidazole ring is more preferable.
The content of the curing catalyst is, with respect to 100% by mass of the solid content excluding the inorganic filler from the subject thermosetting resin composition, preferably from 0.1 to 10% by mass, and particularly preferably from 0.1 to 5% by mass. By setting the content of the curing catalyst to be equal to or more than the above lower limit, the progress of the curing reaction can be sufficiently promoted to achieve good curing, and by setting the content to be equal to or less than the above upper limit, the curing rate will not be too fast, and therefore the storage stability of the subject thermosetting resin composition can be good.

<Organic solvent>

The subject thermosetting resin composition may optionally contain an organic solvent, if necessary for example, in order to improve coating properties when forming a sheet-like cured product through a coating process.
Examples of the organic solvent that can be contained in the subject thermosetting resin composition include methyl ethyl ketone, cyclohexanone, propylene glycol monomethyl ether acetate, butyl acetate, isobutyl acetate, and

propylene glycol monomethyl ether.

These organic solvents may be used alone or in combination of two or more.

When the subject thermosetting resin composition contains an organic solvent, the content is appropriately determined depending on the ease of handling and the like during production of the subject thermally conductive resin sheet. Usually, it is preferable to use the organic solvent so that the solid content (total of components other than the solvent) concentration in the subject thermosetting resin composition is from 10 to 90% by mass, and in particular 40% by mass or more or 80% by mass or less.

In the case of forming a sheet, it is preferable to use the organic solvent so that the solid content (total of components other than the solvent) concentration in the subject thermosetting resin composition is 95% by mass or more, more preferably 97% by mass or more, further preferably 98% by mass or more, and still further preferably 99% by mass or more.

<Other components>

The subject thermosetting resin composition may contain other components in addition to the components described above.

Examples of the other components include a dispersant, a thermoplastic resin, an organic filler, an inorganic filler, an additive such as a silane coupling agent that improves the interfacial adhesive strength between an inorganic filler and the resin component, an additive that can be expected to have an effect of increasing the adhesion strength between a resin sheet and a metal plate, an insulating carbon component such as a reducing agent, a viscosity modifier, a thixotropic agent, a flame retardant, a colorant, a phosphorus-based, phenol-based, or other type of antioxidant, a phenol acrylate or other type of process stabilizer, a heat stabilizer, a hindered amine radical scavenger (HAAS), an impact modifier, a processing aid, a metal deactivator, a copper inhibitor, an antistatic agent, and a bulking agent. When these additives are used, they may be added in amounts generally within the range of amounts used for these purposes.

<Physical properties of subject thermosetting resin composition>

The subject thermosetting resin composition can have, when formed into a sheet and cured, a thermal conductivity of 10 W/mK or more in the thickness direction at 25°C, and of that, 13 W/mK or more, and of that, 15 W/mK or more.

<<Uses of subject thermosetting resin compositions

The subject thermosetting resin composition can be used in various applications where thermal conductivity is required.

<Thermally conductive resin sheet>

The thermally conductive resin sheet according to one example of the embodiment of the present invention (referred to as "subject thermally conductive resin sheet") may be a thermally conductive resin sheet formed from a cured product of the subject thermosetting resin composition.

The thermal conductivity of the subject thermally conductive resin sheet in the thickness direction at 25°C is preferably 10 W/m·K or more, particularly preferably 15 W/m·K or more, and of that, more preferably 17 W/m·K or more. By setting the thermal conductivity in the thickness direction to be equal to or more than the above lower limit value, the thermally conductive resin sheet can be suitably used for power semiconductor devices and the like that operate at high temperatures.

The thermal conductivity can be adjusted based on the type of thermosetting resin, the physical property value of the thermosetting resin such as melt viscosity, the structure, oil absorption amount, and content of the boron nitride agglomerated particles, the method of mixing the thermosetting resin and the boron nitride agglomerated particles, the conditions in the heating and kneading process described below, and the like.

The thermal conductivity in the thickness direction of the subject thermally conductive resin sheet can be measured by the following method.

For example, the thermal conductivity can be determined using a thermal resistance measuring device (manufactured by Mentor Graphics Corporation, trade name "T3ster"), from the slope of a graph obtained by plotting the thermal resistance value against thickness.

The lower limit of the thickness of the subject thermally conductive resin sheet is preferably 50 μm or more, more preferably 60 μm or more, and further preferably 70 μm or more. On the other hand, the upper limit of the thickness is preferably 400 μm or less, more preferably 300 μm or less, and further preferably 250 μm or less.

By setting the thickness of the subject thermally conductive resin sheet to 50 μm or more, sufficient voltage resistance characteristics can be ensured. On the other hand, by setting the thickness to 400 μm or less, in particular when using the thermally conductive resin sheet for a power semiconductor device and the like, it is possible to achieve a smaller and thinner device, and as a result of the greater thinness, it is also possible to obtain an effect of a reduction in thermal resistance in the thickness direction as compared to thermally conductive layer having insulating properties made of a ceramic material.

An example of a thermally conductive resin sheet according to another example of the embodiment of the present invention (referred to as "subject thermally conductive resin sheet") is a thermally conductive resin sheet composed of a cured product of a thermosetting resin composition containing a thermosetting resin and an inorganic filler, characterized in that the thermally conductive resin sheet includes boron nitride agglomerated particles as the inorganic filler, and includes an epoxy compound and a benzoxazine compound as the thermosetting resin, and the thermally conductive resin sheet has a glass transition temperature of 160°C or higher and lower than 250°C.

It is thought that by setting the glass transition temperature of the thermally conductive resin sheet to 160°C or higher, changes in physical properties at the operating temperature are smaller, and by setting the glass transition temperature to less than 250°C, cracking and peeling can be suppressed because stress is relaxed under high temperature conditions such as during solder reflow.

From this viewpoint, the glass transition temperature of the subject thermally conductive sheet is preferably 160°C or higher and less than 250°C, more preferably, of that, 165°C or higher or less than 240°C, and further preferably, of that, 170°C or higher or less than 230°C.

An example of a thermally conductive resin sheet according to yet another example of the embodiment of the present invention (referred to as "subject thermally conductive resin sheet") is a thermally conductive resin sheet composed of a cured product of a thermosetting resin composition containing a thermosetting resin and an inorganic filler, characterized in that the thermally conductive resin sheet includes boron nitride agglomerated particles as the inorganic filler, and includes an epoxy compound and a benzoxazine compound as the thermosetting resin, and the thermally conductive resin sheet has an average coefficient thermal expansion from 0°C to 175°C of 20 ppm or more and 30 ppm or less.

It is thought that by setting the average coefficient thermal expansion of the thermally conductive resin sheet to 30 ppm or less, a difference in linear expansion with a metal substrate is suppressed, and by setting the average coefficient thermal expansion to 20 ppm or more, a difference in linear expansion with an aluminum substrate, aluminum wiring, and the like is suppressed, and so cracking and peeling can be suppressed.

From this viewpoint, the average coefficient thermal expansion of the subject thermally conductive sheet is preferably 20 ppm or more and 30 ppm or less, more preferably, of that, 21 ppm or more or 29 ppm or less, and further preferably, of that, 22 ppm or more or 28 ppm or less

<Method for producing thermally conductive resin sheet>

An example of a method for producing the subject thermally conductive resin sheet will now be described.

The subject thermally conductive resin sheet can be produced by forming the subject thermosetting resin composition into a sheet (this process is referred to as a "film forming process"), drying as necessary (this process is referred to as a "drying process"), and further applying pressure as necessary (this process is referred to as a "pressurizing process"). Then, the sheet-like resin composition obtained in this way can be cured to produce the subject thermally conductive resin sheet as a sheet-like cured product (this process is referred to as a "curing process").

(Film forming process)

For example, a slurry-like subject thermosetting resin composition can be formed into a sheet by a coating method such as a blade method, a solvent casting method, an extrusion film forming method.

When forming a sheet-like film using the above-mentioned coating method, first, a slurry-like subject thermosetting resin composition is coated on the surface of a base material to form a coated film. That is, a coated film is formed on the base material by using a slurry-like subject thermosetting resin composition with a dipping method, a spin coating method, a spray coating method, a blade method, or any other arbitrary methods.

A coating device such as a spin coater, a slit coater, a die coater, and a blade coater can be used to carry out the coating of the slurry-like subject thermosetting resin composition. With such a coating device, it is possible to uniformly form a coated film of a predetermined thickness on the base material.

As the base material, a copper plate or copper foil, or a PET film, which will be described later, is generally used, but the base material is not limited in any way.

(Drying process)

The subject thermosetting resin composition formed into a sheet as described above is dried at a temperature of usually from 10 to 150°C, preferably from 25 to 120°C, and more preferably from 30 to 110°C, in order to remove solvents and low molecular weight components.
By setting the drying temperature to be equal to or lower than the above upper limit value, curing of the resin in the subject thermosetting resin composition is suppressed, and the resin in the sheet-like resin composition flows during the subsequent pressurizing process, which tends to make it easier to remove voids. By setting the drying temperature to be equal to or higher than the above lower limit value, the solvent can be effectively removed and productivity tends to be improved.
The drying time is not particularly limited and can be adjusted as appropriate depending on the state of the subject thermosetting resin composition, the drying environment, and the like. The drying time is preferably 1 minute or more, more preferably 2 minutes or more, and further preferably 5 minutes or more. The drying time is preferably 24 hours or less, more preferably 10 hours or less, further preferably 4 hours or less, and particularly preferably 2 hours or less.
By setting the drying time to be equal to or more than the above lower limit value, the solvent can be sufficiently removed, and it tends to be possible to suppress the residual solvent from forming voids in the resin cured product. By setting the drying time to be equal to or less than the above upper limit value, productivity tends to be improved and it tends to be possible to suppress manufacturing costs.

(Pressurizing process)

After the drying process, it is desirable to apply pressure on the obtained sheet-like subject thermosetting resin composition for the purpose of bonding the agglomerated inorganic filler particles together to form a heat conduction path, the purpose of eliminating voids and gaps within the sheet, the purpose of improving adhesion to the base material, and the like. However, depending on the purpose, it may not be required to apply pressure.
In the pressurizing process, it is desirable to carry out the process by applying a load of 2 MPa or more on the sheet-like subject thermosetting resin composition on the base material.
The load is preferably 5 MPa or more, more preferably 7 MPa or more, and further preferably 9 MPa or more. The load is preferably 1500 MPa or less, more preferably 1000 MPa or less, and further preferably 800 MPa or less.
By setting the load during pressurization to be equal to or less than the above upper limit value, a sheet having high thermal conductivity in which the secondary particles of the agglomerated inorganic filler are not destroyed and with no voids and the like in the sheet-like subject thermosetting resin composition can be obtained. By setting the load to be equal to or more than the above lower limit value, contact among the agglomerated inorganic filler particles is good and a heat conduction path is easily formed, and so a resin cured product having high thermal conductivity can be obtained.
The heating temperature of the sheet-like subject thermosetting resin composition on the substrate in the pressurizing process is not particularly limited. The heating temperature is preferably 10°C or higher, more preferably 20°C or higher, and further preferably 30°C or higher. The heating temperature is preferably 300°C or lower, more preferably 250°C or lower, further preferably 200°C or lower, still further preferably 100°C or lower, and particularly preferably 90°C or lower.
By performing the pressurizing process in this temperature range, the melt viscosity of the resin in the sheet-like subject thermosetting resin composition can be lowered, and voids and gaps in the resin cured product can be further reduced. In addition, by heating at a temperature equal to or less than the above upper limit value, it tends to be possible to suppress the decomposition of organic components in the sheet-like resin composition and the resin cured product, and to suppress voids generated by residual solvent.
The pressurizing process time is not particularly limited. The pressurizing process time is preferably 30 seconds or more, more preferably 1 minute or more, further preferably 3 minutes or more, and particularly preferably 5 minutes or more. The pressurizing process time is preferably 1 hour or less, more preferably 30 minutes or less, and further preferably 20 minutes or less.
By setting the pressurization time to be equal to or less than the above upper limit value, it tends to be possible to suppress the production time of the resin cured product, and to reduce production costs. By setting the pressurization time to be equal to or more than the above lower limit value, it tends to be possible to sufficiently remove voids and gaps in the resin cured product, and to improve heat transfer performance and voltage resistance characteristics.

(Curing process)

The subject thermosetting resin composition can be cured by heating.
At this time, the heating temperature is preferably from 30 to 400°C, of that, more preferably 50°C or higher, and of that, further preferably 90°C or higher. On the other hand, of that, the temperature is preferably 300°C or lower, and of that,

more preferably 250°C or lower.

The curing process in which the subject thermosetting resin composition undergoes a complete curing reaction may be performed under pressure or without pressure. In the case of applying pressure, it is desirable to perform the curing process under the same conditions as the above-described pressing process for the same reasons as above. In addition, the pressing process and the curing process may be performed simultaneously.

In particular, in a sheet-forming process that includes a pressurizing process and a curing process, it is preferable to perform the pressurization and curing by applying a load in the above range.

The load when performing the pressurizing process and the curing process at the same time is not particularly limited. In this case, it is preferable to apply a load of 5 MPa or more on the sheet-like subject thermosetting resin composition on the base material, more preferably 7 Pa or more, further preferably 9 MPa or more, and particularly preferably 20 MPa or more. Further, the load is preferably 2000 MPa or less, and more preferably 1500 MPa or less.

By setting the load when performing the pressurizing process and the curing process simultaneously to be equal to or less than the above upper limit value, a sheet-like cured product having high thermal conductivity in which the secondary particles of the agglomerated inorganic filler are not destroyed and with no voids and the like in the sheet-like subject thermosetting resin composition can be obtained. Further, by setting the load to be equal to or more than the above lower limit value, contact among the agglomerated inorganic filler particles is good and a heat conduction path is easily formed, and so a resin cured product having high thermal conductivity can be obtained.

When performing the pressurizing process and the curing process simultaneously, the pressurization time is not particularly limited. The pressurization time is preferably 30 seconds or more, more preferably 1 minute or more, further preferably 3 minutes or more, and particularly preferably 5 minutes or more. Further, the pressurization time is preferably 1 hour or less, more preferably 30 minutes or less, and further preferably 20 minutes or less.

By setting the pressurization time to be equal to or less than the above upper limit value, it tends to be possible to suppress the production time of the sheet-like resin cured product, and to reduce production costs. By setting the pressurization time to be equal to or more than the above lower limit value, it tends to be possible to sufficiently remove the sheet-like resin cured product, that is, gaps and voids in the subject thermally conductive resin sheet, and to improve heat transfer performance and voltage resistance characteristics.

<<Heat-dissipating laminated body>>

The heat-dissipating laminated body according to an example of the embodiment of the present invention (referred to as "subject heat-dissipating laminated body") may be a laminated body provided with the subject thermally conductive resin sheet.

An example of the subject heat-dissipating laminated body is a body in which a heat dissipation metal layer including a heat-dissipating material is laminated on one surface of the subject thermally conductive resin sheet.

The heat-dissipating material is not particularly limited as long as it is made of a material having good thermal conductivity. Among such materials, in order to increase the thermal conductivity in the laminated structure, it is preferable to use a metal material for heat dissipation, and of those, it is more preferable to use a flat metal material.

The material substance of the metal material is not particularly limited. Of those, a copper plate, an aluminum plate, an aluminum alloy plate, and the like are preferable because they have good thermal conductivity and are relatively inexpensive.

Regarding the lamination and integration of the subject thermally conductive resin sheet and the heat dissipation metal layer, press molding, which is a batch process, can be preferably used. The press equipment, press conditions, and the like in this case are the same range as the press molding conditions for obtaining the thermally conductive resin sheet described above.

<<Heat-dissipating circuit board>>

The heat-dissipating circuit board according to an example of the embodiment of the present invention (referred to as "subject heat-dissipating circuit board") may be any board that includes the subject thermally conductive resin sheet.

An example of a subject heat-dissipating circuit board has a structure obtained by laminating the above-described heat dissipation metal layer on one surface of a subject thermally conductive resin sheet, and forming a circuit substrate by, for example, an etching treatment and the like on the other surface of the thermally conductive resin sheet to that of the heat dissipation metal layer. Specifically, a "heat dissipation metal layer/thermally conductive resin sheet/-conductive circuit" integrated structure is more preferable. Examples of the state before circuit etching include, for an integrated structure of "heat dissipation metal layer/thermally conductive resin sheet/metal layer for forming conductive circuit", a state in which the metal layer for forming the conductive circuit is flat, and is formed on the entire surface of one side of the thermally conductive resin sheet or formed on a part of the area of the thermally conductive resin sheet.

The material of the metal layer for forming the conductive circuit is not particularly limited. Generally, from the

viewpoint of good electrical conductivity, good etching properties, and cost, it is preferable to form a thin copper plate having a thickness of 0.05 mm or more and 1.2 mm or less.

<<Semiconductor device>>

The semiconductor device according to an example of the embodiment of the present invention (referred to as "subject semiconductor device") may be any device that includes the subject heat-dissipating circuit board.
An example of the subject semiconductor device is a device that includes a structure having a silicon wafer or rewiring layer on which pre-segmented semiconductor chips are mounted formed on the subject heat-dissipating circuit board.

<<Power module>>

The power module according to an example of the embodiment of the present invention (referred to as "subject power module") may be any module as long as it includes the subject thermally conductive resin sheet.
An example of the subject power module is a module having the subject thermally conductive resin sheet mounted as a heat-dissipating circuit board on a power semiconductor device.
In this power semiconductor device, other than the thermally conductive resin sheet or laminated heat-dissipating sheet, conventionally known members may be used as appropriate for the aluminum wiring, sealing material, packaging material, heat sink, thermal paste, and solder.

<<Explanation of terms>>

In the present invention, unless otherwise specified, the expression "from X to Y" (X and Y are arbitrary numbers) means "X or more and Y or less", and includes the meaning "preferably larger than X" or "preferably smaller than Y".
In addition, the expression "X or more" (X is an arbitrary number) or "Y or less" (Y is an arbitrary number) are also intended to include the meaning "preferably more than X" or "preferably less than Y".
In the present invention, the term "sheet" conceptually includes sheets, films, and tapes.

Examples

Hereinafter, the present invention will be explained in more detail with reference to examples. However, the present invention is not limited to the following examples as long as the spirit of the present invention is not exceeded.

<Materials used>

The materials used in the examples and comparative examples are as follows.

(Inorganic filler)

- Inorganic filler A: Spherical boron nitride agglomerated particles having a card-house structure produced based on International Publication No. WO 2015/119198 (average particle size (D50) 45 μm, maximum particle size (Dmax) 90 μm), breaking strength 6 MPa, elastic modulus 65 MPa
- Inorganic filler B: Spherical alumina particles manufactured by Admatex

Volume average particle size: 6.5 μm, thermal conductivity: 20 to 30 W/m·K

(Polymer)

- Resin component 1: Bifunctional epoxy resin disclosed as resin component 1 in Japanese Patent Laid-Open No. 2020-63438, mass average molecular weight in terms of polystyrene: 30,000, epoxy equivalent: 9,000 g/equivalent

(Epoxy compound)

- Resin component 2: Biphenyl type solid epoxy compound manufactured by Mitsubishi Chemical, molecular weight: approximately 400, epoxy equivalent: 200 g/equivalent
- Resin component 3: Polyfunctional epoxy compound including a structure having 4 or more glycidyl groups per molecule, manufactured by Nagase ChemteX, molecular weight: approximately 400, epoxy equivalent: 100 g/equivalent

Does not include amine or amide structures that contain nitrogen atoms.

(Benzoxazine compound)

- Resin component 4: P-d type benzoxazine manufactured by Shikoku Kasei, solid (25°C), in formula (III), $X^2$ is $CH_2$
- Resin component 5: CR-276 manufactured by Tohoku Chemical Industries, liquid at 25°C, viscosity: approximately 7,100 mPa·s (25°C), in formula (V), R is an aliphatic hydrocarbon

(Curing agent)

- Curing agent 1: MEH-8000H manufactured by Meiwa Plastic Industries, phenol resin curing agent

(Curing catalyst)

- Curing catalyst 1: "2E4MZ-A" manufactured by Shikoku Kasei

  2,4-diamino-6-[2'-ethyl-4'-methylimidazolyl-(17')]-ethyl-s-triazine
  (One molecule contains both an imidazole-derived structure and a triazine-derived structure)
  Molecular weight: 247, properties: solid, melting point: 215 to 225°C

- Curing catalyst 2: "2PHZ-PW" manufactured by Shikoku Kasei

  2-phenyl-4,5-dihydroxymethylimidazole
  Molecular weight: 204, property: solid, melting point: dec. 230, and so the melting point is 230°C or higher.

[Average particle size (D50) and maximum particle size (Dmax)]

The average particle size (D50) and maximum particle size (Dmax) of the particles of the inorganic filler A are the maximum particle size Dmax and cumulative volume 50% particle size (average particle size D50) determined from a particle size distribution obtained by dispersing the inorganic filler in a pure water medium containing sodium hexametaphosphate as a dispersion stabilizer, and measuring the particle size distribution using a laser diffraction/scattering particle size distribution analyzer LA-300 (manufactured by Horiba, Ltd.).
The volume average particle size of the inorganic filler B is the average particle size determined from the results of measuring the volume average particle size distribution using a laser diffraction particle size distribution analyzer.

[Measurement of breaking strength and elastic modulus of agglomerated inorganic filler]

The breaking strength and elastic modulus of the agglomerated inorganic filler were measured using the following method.
The breaking strength of the agglomerated inorganic filler was measured using a micro compression tester (manufactured by Shimadzu Corporation, trade name "MCT-510").
A very small amount of a sample was spread on a pressure plate arranged at the bottom of the micro compression

tester, a compression test was performed one particle at a time, and the breaking strength was determined using the following formula from the break test force when the particles broke and the particle size of the particles. The measurement was carried out on 5 particles, and the average value was taken as the breaking strength of the agglomerated inorganic filler.

$$Cs=2.48P/\pi d^2$$

"Cs" is the breaking strength (MPa), "P" is the break test force (N), and "d" is the particle size (mm).

Normally, breaking strength is calculated using the test force at the break point, but if the break point is not clear (for example, the sample deforms but does not break suddenly), the test force when applying 10% deformation as a reference strength was taken as the 10% strength for comparison. The 10% strength was calculated using the following formula.

$$Cx=2.48P/\pi d^2$$

In the formula, "Cx" is the 10% strength (MPa), "P" is the test force (N) at 10% displacement of particle size, and "d" is the particle size (mm).

The elastic modulus of the agglomerated inorganic filler was calculated using the following formula from the test force at the time of break and the compressive displacement at that time using the device used to measure the breaking strength.

$$E=3\times(1-\nu^2)\times P/4\times(d/2)^{1/2}\times Y^{3/2}$$

In the formula, "E" is the elastic modulus (MPa), "v" is Poisson's ratio, "P" is the destructive test force (N), "d" is the particle size (mm), and "Y" is the compressive displacement (mm). Poisson's ratio was assumed to be constant (0.13).

<Examples 1, 2, 3, and 4, and Comparative Examples 1, 2, 3, 4, and 5>

Using a rotation-revolution type mixer inorganic fillers A and B, resin components 1, 2, 3, and 4, curing agent 1, and thermosetting catalysts 1 and 2 were added to and mixed with an organic solvent composed of methyl ethyl ketone and cyclohexanone in the mass ratios shown in Table 1 to prepare a thermosetting resin composition as a coating slurry. At this time, the methyl ethyl ketone and cyclohexanone were used so that the solid content concentration was 65% by mass.

The coating slurry was coated on a PET film base material using a doctor blade method, and dried at 60°C for 120 minutes to obtain a sheet-like molded article having a thickness of 220 μm.

<Evaluation of film forming properties>

In the examples and comparative examples, the appearance of the sheet-like molded article was visually evaluated. In addition, film forming properties were evaluated by cutting the sheet-like molded article and the PET film base material together with scissors and observing the cross section.

(Appearance evaluation)

○ (Pass): The filler was uniformly dispersed on the coated film and there was no unevenness.

× (Fail): Agglomeration of filler were observed on the coated film, and the coating surface was uneven.

(Evaluation of film forming properties)

○ (Pass): The sheet did not crack or peel from the base material when cut with scissors.
× (Fail): The sheet cracked or peeled from the base material when cut with scissors.

<Evaluation of thermally conductive resin sheet>

(Measurement of storage modulus (E') and glass transition temperature (Tg))

The sheet-like molded articles obtained in the examples and comparative examples were peeled off from the base material, three sheets were stacked, and while pressurized from above and below with a load of 10 MPa, the stacks were heated and cured under the curing conditions shown in Table 1 to obtain a thermally conductive resin sheet. At this time, for example, in Example 1, the sample was heated at 175°C for 30 minutes and then heated at 200°C for 30 minutes.
The obtained thermally conductive resin sheet was cut into a measurement sample of about 4 mm width × 50 to 60 mm length, and the storage modulus (E') and glass transition temperature (Tg) were measured under the following conditions.
The measurement was carried out using a measurement device "DMS6100" manufactured by Hitachi High-Tech Science under the following conditions.

Measurement temperature conditions: -110 to 270°C
Measurement mode: tensile mode
Measurement frequency: 1 Hz
Chuck gap: 35 mm
Distortion amplitude (μm): 5 μm
Initial force amplitude value (mN):50 mN

In addition, regarding Comparative Examples 2, 3, and 5, measurement samples for measuring the storage modulus (E') and glass transition temperature (Tg) could not be produced because the film forming properties were poor.

(Storage modulus (E') @200°C evaluation)

The storage modulus (E') @200°C was evaluated as "○ (pass)" if the storage modulus was 1E+9Pa or more, and " × (fail)" if the storage modulus was less than 1E+9Pa.

(Evaluation of heat resistance)

The glass transition temperature (Tg) was determined from the peak value of Tanδ.
Measurement samples having a glass transition temperature (Tg) of 160°C or more and less than 250°C were evaluated as heat resistance "○ (pass)", and measurement samples having a glass transition temperature (Tg) of less than 160°C or 250°C or higher were evaluated as heat resistance "× (fail)".

(Coefficient of thermal expansion)

The sheet-like molded articles obtained in the examples and comparative examples were peeled off from the base material, three sheets were stacked, and while pressurized from above and below with a load of 10 MPa, the stacks were heated and cured under the conditions shown in Table 1 to obtain a thermally conductive resin sheet. At this time, for example, in Example 1, the sample was heated at 175°C for 30 minutes and then heated at 200°C for 30 minutes.
The obtained thermally conductive resin sheet was cut to an approximately 4 mm width × 30 mm length, and the coefficient of thermal expansion (CTE) was measured under the following conditions.
EXSTAR TMA/SS6100 (manufactured by Hitachi High-Tech Science)
Measurement temperature conditions: -50°C to 230°C,
measured under a nitrogen atmosphere
Temperature rising phase: 5°C/min
Temperature falling phase: 10°C/min
Measurement mode: tensile mode
Chuck gap: 20 mm

The coefficient of thermal expansion was measured during the second temperature rising phase.

[Evaluation of coefficient of thermal expansion]

Measurement samples whose average coefficient of thermal expansion from 0°C to 175°C was 20 ppm or more and 30 ppm or less were evaluated as "○ (pass)", and measurement samples that were less than 20 ppm or more than 30 ppm were evaluated as "× (fail)".

[Thermal conductivity in the thickness direction of thermally conductive resin sheet]

The sheet-like molded articles obtained in the examples and comparative examples were heated and cured under the conditions shown in Table 1 while being pressurized at 10 kgf/$cm^2$ to obtain thermally conductive resin sheets (measurement samples).

In addition, by stacking two, three, or four sheets of the sheet-like resin compositions obtained in the examples and comparative examples, and applying pressure in the same manner as above, four types of sheet-like resin cured products, that is, in other words, thermally conductive resin sheets (measurement samples), having different thicknesses were obtained.

These four types of thermally conductive resin sheets (measurement samples) having different thicknesses were measured, and the thermal conductivity at 25°C in the sheet thickness direction was measured using the steady state method (in accordance with ASTMD5470) from the slope expressed by the thermal resistance value with respect to the sheet thickness.

(1) Thickness: Thickness (μm) when pressed at a press pressure of 3400 kPa using a T3Ster-DynTIM manufactured by Mentor Graphics.
(2) Measurement area: Area of the portion that transfers heat ($cm^2$) when measured using a T3Ster-DynTIM manufactured by Mentor Graphics
(3) Thermal resistance value: Thermal resistance value (K/W) when pressed at a press pressure of 3400 kPa using a T3Ster-DynTIM manufactured by Mentor Graphics
(4) Thermal conductivity: The thermal resistance value of four sheets having different thicknesses was measured, and the thermal conductivity (W/m·K) was calculated from the following formula.

thermal conductivity (W/m·K)=1/((slope (thermal resistance value/thickness) : K/ (W·μm)) × (area: $cm^2$))×$10^{-2}$ Formula:

In addition, regarding Comparative Examples 2, 3, and 5, the above measurement samples for measuring thermal conductivity could not be produced because the film forming properties were poor.

Based on the measured thermal conductivity in the thickness direction, the thermal conductivity was evaluated according to the following criteria.

"○ (Pass)": 10 W/m·K or more
"× (Fail)": Less than 10 W/m·K

<Measurement of adhesive strength>

The sheet-like molded articles obtained in the examples and comparative examples were cut to 25 mm × 60 mm, sandwiched between a 25 mm × 120 mm copper plate and a 25 mm × 60 mm copper plate, and then while a further copper plate was placed so that the thickness was uniform, cured by pressing at 10 MPa under the peel strength test curing conditions shown in Table 1 (for example, in Example 1, heated at 125°C for 30 minutes, then heated at 175°C for 30 minutes, and further heated at 200°C for 30 minutes) to obtain a sample for evaluating adhesive properties having a thermally conductive resin sheet. At this time, a C1100P-1/4H copper plate with a thickness of 0.1 mm was used as the copper plates sandwiching the sheet-like molded article, and a 0.5 mm thick copper plate was used as the copper plate for adjusting the thickness.

The surface of the 25 mm × 60 mm copper plate opposite to the sheet-like molded article of the sample for evaluating adhesive properties was fixed to a resin plate, fixed to a jig, and then a 90 degree peel test between the cured sheet-like molded article (thermally conductive resin sheet) and the 25 mm × 120 mm copper plate was conducted by pulling the 25 mm × 120 mm copper plate vertically. The peel strength (N/cm) was measured using a tensile tester manufactured by ORIENTEC at a tensile speed of 50 mm/min using a 50 N test jig.

Based on the measured peel strength, adhesive properties were evaluated using the following criteria.

Samples having a peel strength of 4.2 N/cm or more were evaluated as "◎ (good pass)", less than 4.2 N/cm and

3.3 N/cm or more as "○ (pass)", and less than 3.3 N/cm as evaluated as "× (fail)". If the film forming properties were so bad that it was impossible to produce a sample for evaluating adhesive properties, an evaluation of "×× (sample cannot be produced)" was given.

[Table 1]

| | | Example 1 | Example 2 | Comparetive Example 1 | Comparetive Example 2 | Comparetive Example 3 | Example 3 | Example 4 | Comparetive Example 4 | Comparetive Example 5 |
|---|---|---|---|---|---|---|---|---|---|---|
| Compositional feature of resin composition (parts by mass) | Inorganic filler A | 100 | 100 | 100 | 100 | 100 | 100 | 100 | 100 | 100 |
| | Inorganic filler B | 38 | 38 | 38 | 38 | 38 | 0 | 0 | 0 | 38 |
| | Resin component 1 | 11 | 12 | 12 | 0 | 0 | 9.8 | 7.50 | 7.50 | 11.44 |
| | Resin component 2 | 18 | 19 | 19 | 25 | 15 | 7.8 | 9.72 | 14.01 | 7.55 |
| | Resin component 3 | 9.2 | 9.4 | 9.4 | 12.5 | 7.7 | 14.0 | 14.01 | 14.01 | 3.77 |
| | Resin component 4 | 6.4 | 6.5 | 0.0 | 8.8 | 23.1 | 6.3 | 6.25 | 1.96 | 22.8 |
| | | | | | | | | | | |
| | Curing agent 1 | 0.0 | 0.0 | 6.5 | 0.0 | 0.0 | | | | |
| | Curing catalyst 1 | 1.2 | 0.5 | 0.5 | 0.5 | 0.5 | 0.9 | 0.9 | 0.9 | 1.2 |
| | Curing catalyst 2 | 0.5 | 0.5 | 0.5 | 0.5 | 0.5 | 0.3 | 0.3 | 0.3 | 0.5 |
| | Resin component epoxy equivalent (g/equivalent) | 214 | 214 | 214 | 192 | 312 | 176 | 167 | 171 | 303 |
| | Proportion (% by mass) of boron nitride agglomerated particles with respect to 100% by mass of the total solid content of the thermosetting resin composition | 54.1 | 54.1 | 54.1 | 54.1 | 54.1 | 72.1 | 72.1 | 72.1 | 54.1 |
| | Proportion (% by mass) of benzoxazine compound with respect to 100% by mass of the total solid content of the thermosetting resin composition | 3.48 | 3.53 | 0 | 4.88 | 12.5 | 4.51 | 4.50 | 1.41 | 12.3 |

(continued)

| | | Example 1 | Example 2 | Comparetive Example 1 | Comparetive Example 2 | Comparetive Example 3 | Example 3 | Example 4 | Comparetive Example 4 | Comparetive Example 5 |
|---|---|---|---|---|---|---|---|---|---|---|
| | Boron nitride agglomerated particles/benzoxazine compound | 15.6 | 15.3 | - | 11.6 | 4.33 | 16.0 | 16.0 | 51.1 | 4.39 |
| | Polymer/benzoxazine compound | 1.77 | 1.77 | - | 0.0 | 0.0 | 1.21 | 1.55 | 3.84 | 0.50 |
| | Epoxy/benzoxazine compound | 4.32 | 4.32 | - | 4.35 | 1.00 | 3.45 | 3.79 | 14.33 | 0.50 |
| | Benzoxazine compound/epoxy | 0.23 | 0.23 | - | 0.23 | 1.00 | 0.29 | 0.26 | 0.07 | 2.01 |
| Cured product of resin componen t (thermally conductive sheet) | Sheet appearance | ○ | ○ | ○ | × | × | ○ | ○ | ○ | × |
| | Film fanning properties | ○ | ○ | ○ | × | × | ○ | ○ | ○ | × |
| | Curing conditions (two-step curing) | 175°C 30 min + 200°C 30 min | 175°C 30 min + 200°C 120 min | 175°C 30 min + 200°C 120 min | - | - | 175°C 30 min + 200°C 30 min | 175°C 30 min + 200°C 120 min | 175°C 30 min + 200°C 120 min | - |
| | Average coefficient thermal expansion from 0°C to 175°C (ppm) | 25 | | 30 | - | - | 30 | 23 | 23 | - |
| | | ○ | | ○ | - | - | ○ | ○ | ○ | - |
| | Storage modulus (E') @200°C | ○ | ○ | ○ | - | - | ○ | ○ | ○ | - |
| | Glass transition temperature (Tg) | 185°C | 180°C | 156°C | - | - | 185°C | 197°C | 185°C | - |
| | | ○ | ○ | × | - | - | ○ | ○ | ○ | - |
| | Curing conditions for peel strength test | 120°C 30 min 175°C 30 min 200°C 30 min | 120°C 30 min 175°C 30 min 200°C 30 min | 120°C 30 min 175°C 30 min 200°C 30 min | - | - | 120°C 30 min 175°C 30 min 200°C 30 min | 120°C 30 min 175°C 30 min 200°C 30 min | 120°C 30 min 175°C 30 min 200°C 30 min | - |
| | Peel strength | ○ | ○ | × | ×× | ×× | ○ | ○ | × | ×× |

From the above examples and test results conducted by the present inventors up to now, it can be seen that it is possible to obtain a sheet-like molded article having excellent thermal conductivity and heat resistance by using a combination of an epoxy compound and a benzoxazine compound as a thermosetting resin, and furthermore, that by blending a polymer having a mass average molecular weight of 10,000 or more, it is possible to form a film without any problems during sheet molding. In addition, it can be seen that sufficient adhesive strength (peel strength) can be obtained when the mass proportion of the boron nitride agglomerated particles to the benzoxazine compound (boron nitride agglomerated particles/benzoxazine) is 5 or more and 50 or less.
The following mechanism of action is presumed to be a factor in achieving such effects.
When the subject thermosetting resin composition is cured, the cured composition does not just have a crosslinked structure formed by an epoxy compound and a crosslinked structure formed by a benzoxazine compound, those crosslinked structures form a composite structure, resulting in a stronger crosslinked structure, so that a higher glass transition temperature (Tg) and better heat resistance can be obtained.
Further, since the subject thermosetting resin composition contains boron nitride agglomerated particles as an inorganic filler, a thermally conductive sheet having excellent thermal conductivity can be provided by curing.
In addition, since a polymer having a mass average molecular weight of 10,000 or more is contained, even if the content proportion of boron nitride agglomerated particles is increased, handling properties can be improved and film forming properties can be improved.
Since the mass proportion of the boron nitride agglomerated particles to the benzoxazine compound, namely, boron nitride agglomerated particles/benzoxazine, is 5 or more and 50 or less, there is a sufficient amount of benzoxazine for the boron nitride agglomerated particles, and thus it is thought that it is possible to sufficiently obtain the effect of improving adhesive properties.
From this mechanism of action, it is inferred that the same effects as the thermosetting resin composition of the examples can be provided by a thermosetting resin composition containing a thermosetting resin, an inorganic filler, and a polymer having a mass average molecular weight of 10,000 or more, wherein boron nitride agglomerated particles are included as the inorganic filler, and an epoxy compound and a benzoxazine compound are included as the thermosetting resin.

<Examples 5 and 6, and Comparative Example 6>

Using a rotation-revolution type mixer, inorganic fillers A and B, resin components 1, 2, 3, 4, and 5, curing agent 1, and thermosetting catalysts 1 and 2 were added to and mixed with an organic solvent composed of methyl ethyl ketone and cyclohexanone in the mass ratios shown in Table 2 to prepare a thermosetting resin composition as a coating slurry. At this time, the methyl ethyl ketone and cyclohexanone were used so that the solid content concentration was 65% by mass.
The coating slurry was coated on a PET film base material using a doctor blade method, and dried at 60°C for 120 minutes to obtain a sheet-like molded article having a thickness of 220 μm.

<Evaluation of thermally conductive resin sheet>

Thermally conductive resin sheets (cured products) were produced from the sheet-like molded articles obtained in the examples and comparative examples, and evaluated as follows.

(Measurement of storage modulus (E') and glass transition temperature (Tg))

The sheet-like molded articles obtained in the examples and comparative examples were peeled off from the base material, three sheets were stacked, and while pressurized from above and below with a load of 10 MPa, the stacks were heated and cured under the curing conditions shown in Table 2 (for E' and λ measurements) to obtain a thermally conductive resin sheet. At this time, for example, in Example 5, the sample was heated at 175°C for 30 minutes and then heated at 200°C for 30 minutes.
The obtained thermally conductive resin sheet was cut into a measurement sample of about 4 mm width × 50 to 60 mm length, and the storage modulus (E') and glass transition temperature (Tg) were measured under the following conditions.
The measurement was carried out using a measurement device "DMS6100" manufactured by Hitachi High-Tech Science under the following conditions.

Measurement temperature conditions: -110 to 270°C
Measurement mode: tensile mode
Measurement frequency: 1 Hz
Chuck gap: 35 mm

Distortion amplitude ($\mu$m): 5 $\mu$m
Initial force amplitude value (mN): 50 mN

(Storage modulus (E') @200°C evaluation)

The storage modulus (E') @200°C was evaluated as "○ (pass)" if the storage modulus was 1E+9Pa or more, and " × (fail)" if the storage modulus was less than 1E+9Pa.

(Measurement of adhesive strength)

The sheet-like molded articles obtained in the examples and comparative examples were cut to 25 mm × 60 mm, sandwiched between a 25 mm × 120 mm copper plate and a 25 mm × 60 mm copper plate, and then while a further copper plate was placed so that the thickness was uniform, cured by pressing at 10 MPa under the peel strength test curing conditions shown in Table 2 (for example, in Example 1, heated at 125°C for 30 minutes, then heated at 175°C for 30 minutes, and further heated at 200°C for 30 minutes) to obtain a sample for evaluating adhesive properties having a thermally conductive resin sheet. At this time, a C1100P-1/4H copper plate with a thickness of 0.1 mm was used as the copper plates sandwiching the sheet-like molded article, and a 0.5 mm thick copper plate was used as the copper plate for adjusting the thickness.
The surface of the 25 mm × 60 mm copper plate opposite to the sheet-like molded article of the sample for evaluating adhesive properties was fixed to a resin plate, fixed to a jig, and then a 90 degree peel test between the cured sheet-like molded article (thermally conductive resin sheet) and the 25 mm × 120 mm copper plate was conducted by pulling the 25 mm × 120 mm copper plate vertically. The peel strength (N/cm) was measured using a tensile tester manufactured by ORIENTEC at a tensile speed of 50 mm/min using a 50 N test jig.
Based on the measured peel strength, adhesive properties were evaluated using the following criteria.
Samples having a peel strength of 4.2 N/cm or more were evaluated as "◎ (good pass)", less than 4.2 N/cm and 3.3 N/cm or more as "○ (pass)", and less than 3.3 N/cm as evaluated as "× (fail)".

(Thermal conductivity in the thickness direction of thermally conductive resin sheet ($\lambda$))

The sheet-like molded articles obtained in the examples and comparative examples were heated and cured under the curing conditions shown in Table 2 (for E' and $\lambda$ measurements) to obtain thermally conductive resin sheets (measurement samples). At this time, for example, in Example 5, the articles were heated at 175°C for 30 minutes, and then heated at 200°C for 30 minutes.
In addition, by stacking two, three, or four sheets of the sheet-like resin compositions obtained in the examples and comparative examples, and applying pressure in the same manner as above, four types of sheet-like resin cured products, that is, thermally conductive resin sheets (measurement samples), having different thicknesses were obtained.
These four types of thermally conductive resin sheets (measurement samples) having different thicknesses were measured, and the thermal conductivity ($\lambda$, W/m·K) at 25°C in the sheet thickness direction was measured using the steady state method (in accordance with ASTMD5470) from the slope expressed by the thermal resistance value with respect to the sheet thickness.
(1) Thickness: Thickness ($\mu$m) when pressed at a press pressure of 3400 kPa using a T3Ster-DynTIM manufactured by Mentor Graphics.
(2) Measurement area: Area of the portion that transfers heat ($cm^2$) when measured using a T3Ster-DynTIM manufactured by Mentor Graphics
(3) Thermal resistance value: Thermal resistance value (K/W) when pressed at a press pressure of 3400 kPa using a T3Ster-DynTIM manufactured by Mentor Graphics
(4) Thermal conductivity: The thermal resistance value of four sheets having different thicknesses was measured, and the thermal conductivity (W/m·K) was calculated from the following formula.

Formula: thermal conductivity (W/m·K)=1/((slope (thermal resistance value/thickness): K/ (W·$\mu$m))×(area: $cm^2$))×$10^{-2}$ -->

Based on the measured thermal conductivity in the thickness direction, the thermal conductivity was evaluated according to the following criteria.

"○ (Pass)": 10 W/m·K or more

"× (Fail)": Less than 10 W/m·K

[Table 2]

| | Example 5 | Comparative Example 6 | Example 6 |
|---|---|---|---|
| Inorganic filler A | 100 | 100 | 100 |
| Inorganic filler B | 38 | 38 | 38 |
| Resin component 1 | 12 | 12 | 12 |
| Resin component 2 | 19 | 19 | 19 |
| Resin component 3 | 9.4 | 9.4 | 9.4 |
| Resin component 4 | | | 6.5 |
| Resin component 5 | 6.5 | | |
| Curing agent 1 | | 6.5 | |
| Curing catalyst 1 | 0.5 | 0.5 | 0.5 |
| Curing catalyst 2 | 0.5 | 0.5 | 0.5 |
| Proportion (% by mass) of boron nitride agglomerated particles with respect to 100% by mass of the total solid content of the thermosetting resin composition | 54.14 | 54.14 | 54.14 |
| Proportion (% by mass) of benzoxazine compound with respect to 100% by mass of the total solid content of the thermosetting resin composition | 3.53 | 0 | 3.53 |
| Boron nitride agglomerated particles/benzoxazine compound | 15.3 | - | 15.3 |
| Polymer/benzoxazine compound | 1.77 | - | 1.77 |
| Epoxy/benzoxazine compound | 4.32 | - | 4.32 |
| Benzoxazine compound/epoxy | 0.23 | - | 0.23 |
| Sheet appearance | ○ | ○ | ○ |
| Film forming properties | ○ | ○ | ○ |
| Curing conditions (for E' and λ) | 175°C 30 min<br>200°C 30 min | 175°C 30 min<br>200°C 120 min | 175°C 30 min<br>200°C 120 min |
| Storage modulus (E') @200°C of cured product of resin component | 4.6E+9Pa | 5.8E+9Pa | 5.0E+9Pa |
| | ○ | ○ | ○ |
| Glass transition temperature (Tg) | 150.2°C | | |
| Thermal conductivity | ○ | ○ | ○ |
| Curing conditions for peel strength test | 120°C 30 min<br>175°C 30 min<br>200°C 30 min | 120°C 30 min<br>175°C 30 min<br>200°C 30 min | 120°C 30 min<br>175°C 30 min<br>200°C 10 min |
| Peel strength | ◎ | × | ○ |

From the above examples and test results conducted by the present inventors up to now, it can be seen that it is possible to obtain a sheet-like molded article having excellent thermal conductivity and heat resistance by using a combination of an epoxy compound and a benzoxazine compound that is liquid at 25°C as a thermosetting resin, and furthermore, that a thermally conductive resin sheet having excellent adhesive properties with a base material during curing can be obtained.

The following mechanism of action is presumed to be a factor in achieving such effects.

When the subject thermosetting resin composition is cured, the cured composition does not just have a crosslinked structure formed by an epoxy compound and a crosslinked structure formed by a benzoxazine compound, those crosslinked structures form a composite structure, resulting in a stronger crosslinked structure, so that better heat resistance can be obtained.

Further, since the subject thermosetting resin composition contains boron nitride agglomerated particles as an inorganic filler, a thermally conductive sheet having excellent thermal conductivity can be provided by curing.

In addition, since the benzoxazine is liquid at 25°C, even if the content proportion of boron nitride agglomerated particles is increased, adhesion to the base material can be maintained, film forming properties can be improved, and adhesive strength with the base material during curing can be increased.

From this mechanism of action, it is inferred that the same effects as the thermosetting resin composition of the examples can be provided by a thermosetting resin composition containing a thermosetting resin and an inorganic filler, wherein boron nitride agglomerated particles are included as the inorganic filler, and an epoxy compound and a benzoxazine compound that is liquid at 25°C are included as the thermosetting resin.

Moreover, it can be seen that sufficient adhesive strength (peel strength) can be obtained when the mass proportion of the boron nitride agglomerated particles to the benzoxazine compound (boron nitride agglomerated particles/benzoxazine) is 5 or more and 50 or less.

## Claims

1. A thermosetting resin composition comprising a thermosetting resin, an inorganic filler, and a polymer having a mass average molecular weight of 10,000 or more, wherein the thermosetting resin composition

    includes boron nitride agglomerated particles as the inorganic filler, and
    includes an epoxy compound and a benzoxazine compound as the thermosetting resin, and
    a ratio of a mass content of the boron nitride agglomerated particles to a mass content of the benzoxazine compound (boron nitride agglomerated particles/benzoxazine) is 5 or more and 50 or less.

2. The thermosetting resin composition according to claim 1, wherein the benzoxazine compound is solid at 25°C.

3. A thermosetting resin composition comprising a thermosetting resin and an inorganic filler, wherein the thermosetting resin composition

    includes boron nitride agglomerated particles as the inorganic filler, and
    includes an epoxy compound and a benzoxazine compound that is liquid at 25°C as the thermosetting resin.

4. The thermosetting resin composition according to claim 3, comprising a polymer having a mass average molecular weight of 10,000 or more.

5. The thermosetting resin composition according to claim 3 or 4, wherein a ratio of a mass content of the boron nitride agglomerated particles to a mass content of the benzoxazine compound (boron nitride agglomerated particles/benzoxazine) is 50 or less.

6. The thermosetting resin composition according to any one of claims 1 to 5, wherein a proportion of the boron nitride agglomerated particles is 50% by mass or more and 85% by mass or less with respect to 100% by mass of a total solid content of the thermosetting resin composition.

7. The thermosetting resin composition according to claim 1 or 4, wherein the polymer having a mass average molecular weight of 10,000 or more has a functional group that reacts with the epoxy compound.

8. The thermosetting resin composition according to claim 1, 4 or 7, comprising the polymer having a mass average molecular weight of 10,000 or more in a proportion of 10% by mass or more and less than 30% by mass with respect to

100% by mass of a solid content excluding the inorganic filler from the thermosetting resin composition.

**9.** The thermosetting resin composition according to any one of claims 1 to 8, wherein a mass ratio of a content of the benzoxazine compound to a content of the epoxy compound in a solid content of the thermosetting resin excluding the inorganic filler (benzoxazine compound/epoxy compound) is less than 0.8.

**10.** The thermosetting resin composition according to any one of claims 1 to 9, comprising at least one compound having imidazole as a curing catalyst.

**11.** The thermosetting resin composition according to any one of claims 1 to 10, wherein the thermosetting resin includes a polyfunctional epoxy compound having three or more epoxy groups per molecule and having a molecular weight of 650 or less.

**12.** The thermosetting resin composition according to claim 11, wherein the polyfunctional epoxy compound is an epoxy compound having four or more glycidyl groups in one molecule.

**13.** A thermosetting resin sheet formed from the thermosetting resin composition according to any one of claims 1 to 12.

**14.** A thermally conductive resin sheet that is a cured product of the thermosetting resin sheet according to claim 13.

**15.** A thermally conductive resin sheet composed of a cured product of a thermosetting resin composition containing a thermosetting resin and an inorganic filler, wherein

the thermally conductive resin sheet includes boron nitride agglomerated particles as the inorganic filler, and includes an epoxy compound and a benzoxazine compound as the thermosetting resin, and
the thermally conductive resin sheet has a glass transition temperature of 160°C or higher and lower than 250°C.

**16.** A thermally conductive resin sheet composed of a cured product of a thermosetting resin composition containing a thermosetting resin and an inorganic filler, wherein

the thermally conductive resin sheet includes boron nitride agglomerated particles as the inorganic filler, and includes an epoxy compound and a benzoxazine compound as the thermosetting resin, and
the thermally conductive resin sheet has an average coefficient thermal expansion from 0°C to 175°C of 20 ppm or more and 30 ppm or less.

**17.** The thermally conductive resin sheet according to any one of claims 14 to 16, which has a thermal conductivity in the thickness direction at 25°C of 10 W/mK or more.

**18.** A heat-dissipating laminated body comprising the thermally conductive resin sheet according to any one of claims 14 to 17.

**19.** A heat-dissipating circuit board comprising the thermally conductive resin sheet according to any one of claims 14 to 17.

**20.** A semiconductor device comprising the heat-dissipating circuit board according to claim 19.

**21.** A power module comprising the thermally conductive resin sheet according to any one of claims 14 to 17.

Fig. 1

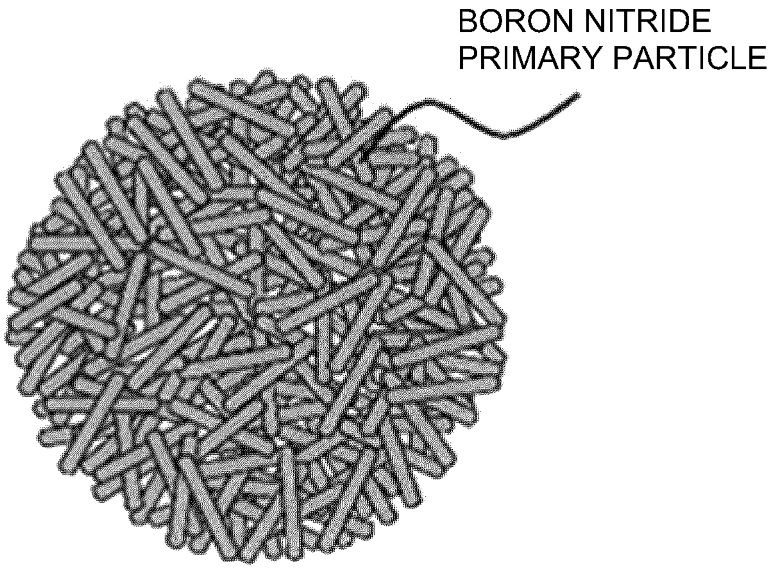

**INTERNATIONAL SEARCH REPORT**

International application No. **PCT/JP2023/011692**

**A. CLASSIFICATION OF SUBJECT MATTER**

***C08L 63/00***(2006.01)i; ***B32B 27/38***(2006.01)i; ***C08K 3/013***(2018.01)i; ***C08K 3/38***(2006.01)i; ***C08K 5/3415***(2006.01)i; ***C08L 61/34***(2006.01)i; ***C08L 101/02***(2006.01)i; ***H05K 1/03***(2006.01)i

FI: C08L63/00 Z; C08K3/013; C08L101/02; C08K3/38; C08K5/3415; C08L61/34; B32B27/38; H05K1/03 610R; H05K1/03 610L

According to International Patent Classification (IPC) or to both national classification and IPC

**B. FIELDS SEARCHED**

Minimum documentation searched (classification system followed by classification symbols)

C08L1/00-101/16; C08K3/00-13/08; B32B1/00-43/00; H05K1/03

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2020-196807 A (SUMITOMO BAKELITE CO., LTD.) 10 December 2020 (2020-12-10) claims, paragraphs [0019], [0025], [0054]-[0058], [0069], [0070], [0079]-[0097], examples 1-10 | 1-21 |
| Y | JP 2019-119883 A (MITSUBISHI CHEMICAL HOLDINGS CORP.) 22 July 2019 (2019-07-22) paragraphs [0016]-[0019], [0036], [0092] | 1-2, 4-21 |
| Y | JP 2001-288339 A (NEC CORP.) 16 October 2001 (2001-10-16) paragraphs [0027], [0092] | 3-21 |
| A | WO 2021/117758 A1 (SUMITOMO BAKELITE CO., LTD.) 17 June 2021 (2021-06-17) claims | 1-21 |
| A | JP 2015-006980 A (MITSUBISHI CHEMICALS CORP.) 15 January 2015 (2015-01-15) claims | 1-21 |

☑ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **18 May 2023** | **30 May 2023** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

INTERNATIONAL SEARCH REPORT

International application No. PCT/JP2023/011692

C. DOCUMENTS CONSIDERED TO BE RELEVANT

| Category* | Citation of document, with indication, where appropriate, of the relevant passages | Relevant to claim No. |
|---|---|---|
| A | JP 2019-196434 A (SUMITOMO BAKELITE CO., LTD.) 14 November 2019 (2019-11-14) claims | 1-21 |
| A | WO 2021/085593 A1 (MITSUBISHI CHEMICAL HOLDINGS CORP.) 06 May 2021 (2021-05-06) claims | 1-21 |

Form PCT/ISA/210 (second sheet) (January 2015)

**INTERNATIONAL SEARCH REPORT**
**Information on patent family members**

International application No.
**PCT/JP2023/011692**

| Patent document cited in search report | Publication date (day/month/year) | Patent family member(s) | Publication date (day/month/year) |
|---|---|---|---|
| JP 2020-196807 A | 10 December 2020 | (Family: none) | |
| JP 2019-119883 A | 22 July 2019 | (Family: none) | |
| JP 2001-288339 A | 16 October 2001 | (Family: none) | |
| WO 2021/117758 A1 | 17 June 2021 | US 2023/0018491 A1<br>claims<br>JP 2021-169615 A<br>CN 114902402 A | |
| JP 2015-006980 A | 15 January 2015 | (Family: none) | |
| JP 2019-196434 A | 14 November 2019 | (Family: none) | |
| WO 2021/085593 A1 | 06 May 2021 | US 2022/0251335 A1<br>claims<br>EP 4053213 A1<br>CN 114641532 A<br>KR 10-2022-0092870 A<br>TW 202124505 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2017036415 A
- JP 5627196 B
- JP 2021084968 A
- WO 2015119198 A
- JP 2020063438 A


### Non-patent literature cited in the description


- Ceramics 43 No. 2. Ceramic Society of Japan, 2008